# EUROPEAN PATENT APPLICATION

(11) **EP 4 664 513 A1**
(43) Date of publication of application: **17.12.2025**
(21) Application number: 25175523.7
(22) Date of filing: 09.05.2025
(51) Int. Cl.: H01L 23/00, H01L 25/065

(54) **PACKAGE ARCHITECTURES HAVING VERTICALLY STACKED DIES WITH DIRECT BONDING**

(30) Priority: 12.06.2024 US 202418740681
(71) Applicant: INTEL Corporation, Santa Clara, CA 95054 (US)
(72) Inventor: CHIDAMBARAM, Vivek, 545119 Singapore (SG); MAHAJAN, Ravindranath Vithal, Chandler, AZ 85248 (US); DUGGAN, Steven, Hillsboro, OR 97124 (US)
(74) Representative: HGF

(57) **Abstract**

Embodiments of a microelectronic assembly may include a first integrated circuit (IC) die having a first surface, an opposing second surface, and a third surface orthogonal to the first and second surfaces, the first IC die including conductive traces parallel to the first and second surfaces and exposed at the third surface; and a second IC die having a fourth surface with conductive contacts, wherein the conductive traces exposed at the third surface of the first IC die are electrically coupled to the conductive contacts at the fourth surface of the second IC die by metal-metal bonds including nanotwinned copper and dielectric-dielectric bonds. In some embodiments, the first IC die may be one of a plurality of first IC dies. In such embodiments, some of the plurality of first IC dies may include memory circuitry and some of the plurality of first IC dies may include compute circuitry.

## Description

### BACKGROUND

Electronic circuits when commonly fabricated on a wafer of semiconductor material, such as silicon, are called integrated circuits (ICs). The wafer with such ICs is typically cut into numerous individual dies. The dies may be wirebonded or soldered to a package substrate. In use, electrical signals and power are passed between the package substrate and the die through the wirebonds or solder. The IC package may be integrated onto an electronic system, such as a consumer electronic system, or servers, such as mainframes.

### BRIEF DESCRIPTION OF THE DRAWINGS

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1A is a schematic cross-sectional view of an example microelectronic assembly, in accordance with various embodiments.
FIG. 1B is a schematic cross-sectional view of another example microelectronic assembly, in accordance with various embodiments.
FIG. 2 is a side, cross-sectional exploded view of a portion of the microelectronic assembly of FIG. 1, in accordance with various embodiments.
FIGS. 3A and 3B are side, cross-sectional views of example direct bonding interfaces, in accordance with various embodiments.
FIG. 3C is a side, cross-sectional view of example microstructures of nanotwinned copper and polycrystalline copper, in accordance with various embodiments.
FIG. 3D is a side, cross-sectional view of example microstructures of nanotwinned copper and fine-grain copper, in accordance with various embodiments.
FIGS. 4A-4D are top views of example direct bonding interfaces, in accordance with various embodiments.
FIGS. 5A-5C are schematic cross-sectional views of example IC die, in accordance with various embodiments.
FIG. 6A is a schematic perspective view of the example IC die of FIG. 5A, in accordance with various embodiments.
FIG. 6B is a schematic perspective view of the example IC die of FIG. 5B, in accordance with various embodiments.
FIG. 6C is a schematic perspective view of the example IC die of FIG. 5C, in accordance with various embodiments.
FIGS. 7A-7I are side, cross-sectional views of example stages in the manufacture of a portion of a microelectronic assembly with direct bonding using nanotwinned copper, in accordance with various embodiments.
FIGS. 8A-8F are side, cross-sectional views of additional example stages in the manufacture of a microelectronic assembly with direct bonding using nanotwinned copper, in accordance with various embodiments.
FIG. 9 is a cross-sectional view of a device package that includes one or more microelectronic assemblies in accordance with any of the embodiments disclosed herein.
FIG. 10 is a cross-sectional side view of a device assembly that includes one or more microelectronic assemblies in accordance with any of the embodiments disclosed herein.
FIG. 11 is a block diagram of an example computing device that includes one or more microelectronic assemblies in accordance with any of the embodiments disclosed herein.

### DETAILED DESCRIPTION

### Overview

For purposes of illustrating IC packages described herein, it is important to understand phenomena that may come into play during assembly and packaging of ICs. The following foundational information may be viewed as a basis from which the present disclosure may be properly explained. Such information is offered for purposes of explanation only and, accordingly, should not be construed in any way to limit the broad scope of the present disclosure and its potential applications.

The trend in the computer industry is to utilize multiple processors in large servers, the multiple processors being coupled together in a single package, such as a Multi-Chip Module (MCM). The multiple processors along with other IC dies containing memory circuits (e.g., cache memory circuits, high-bandwidth memory circuits, etc.) are interconnected by high-speed data buses in the package substrate of the MCM, for example, to enable the totality of processors to operate together. However, current technology in such MCMs is inherently limited in its ability to scale to the bandwidth/distance requirements of next generation servers that could have signal speeds greater than 10 GHz and/or data speeds of 3-10 Terabytes per second. The limitations are primarily associated with bandwidth reduction, signal delay, signal loss, and signal distortion due to various reasons, one of which is the configuration in which the multiple processors are coupled together inside the package.

Current packaging architecture, whether 2D, 2.5D or 3D, utilizes multiple IC dies that are oriented parallel to each other and interconnected by various kinds of interconnects, such as copper microbumps, solder balls, etc. In a general sense, any typical IC die consists of a substrate, an active region in the substrate comprising transistors and other active circuitry, and a metallization stack over the substrate, sharing a contact area with the active region. The metallization stack is the region of the IC die in which the individual devices (e.g., transistors, capacitors, resistors, etc.) are interconnected with conductive traces and conductive vias. Common metals used for the conductive traces and conductive vias are copper and aluminum. The metallization stack typically includes contact pads, insulating layers (e.g., interlayer dielectric (ILD) materials such as silicon oxide), conductive layers comprising the conductive traces, and bonding sites for chip-to-chip or chip-to-package connections. Modern IC dies may include more than ten (10) conductive layers in the metallization stack.

Conventionally, various such IC dies may be stacked within a package in various ways: (1) back-to-back, in which the substrate of one IC die is in direct contact with the substrate of another IC die; (2) back-to-front, in which the substrate of one IC die is in direct contact with the metallization stack of the other IC die; and (3) front-to-front, in which the metallization stacks of the two IC dies are in direct contact. In all these configurations, the IC dies are mutually parallel to each other, with the active circuitry disposed in planes parallel to the contacting areas of adjacent IC dies. Such architecture suffers from certain inherent limitations. For example, compute IC dies comprising high-performance compute circuitry that generates a lot of heat have to be placed on the top of any such stack so that heat can be dissipated properly. Such placement limits the number of high-power compute IC dies that can be placed in a package having a limited (or constrained) footprint.

Microelectronic assemblies disclosed herein may include IC dies that are vertically stacked and electrically coupled at a lateral edge (e.g., stacked back-to-back, back-to-front, or front-to-front, and rotated 90 degrees) to a surface of a base IC die. Such vertically stacked IC packages may include memory IC dies, compute IC dies, or both memory and compute IC dies. The IC dies may be electrically coupled to the IC base die with direct bonding using nanotwinned copper (NTC).

For purposes of illustrating such microelectronic assemblies with direct bonding using NTC, proposed herein, it might be useful to first understand phenomena that may come into play in some microelectronic assemblies where direct bonding may be used. The following foundational information may be viewed as a basis from which the present disclosure may be properly explained. Such information is offered for purposes of explanation only and, accordingly, should not be construed in any way to limit the broad scope of the present disclosure and its potential applications.

Direct bonding has attracted considerable attraction recently for coupling microelectronic components (e.g., two dies, or a die and one of a package substrate, a circuit board, or an interposer). As used herein, the term "direct bonding" is used to include metal-to-metal bonding techniques (e.g., copper-to-copper bonding, or other techniques in which direct bonding contacts (DB contacts) of opposing direct bonding interfaces (DB interfaces) are brought into contact first, then subject to heat and compression) and hybrid bonding techniques (e.g., techniques in which direct bonding dielectric (DB dielectric) of opposing DB interfaces, possibly first subjected to prior surface activation, are brought into contact first, then subject to heat and sometimes compression, or techniques in which the DB contacts and the DB dielectric, possibly first subjected to prior surface activation, of opposing DB interfaces are brought into contact substantially simultaneously, and the subject to heat and sometimes compression). The materials of opposing DB dielectrics can be homogeneous (i.e., have substantially the same material composition) or non-homogeneous (i.e., have different material compositions). In such techniques, the DB contacts, and the DB dielectric at one DB interface (e.g., at a DB interface of a first microelectronic component) are brought into contact with the DB contacts and the DB dielectric at another DB interface (e.g., at a DB interface of a second microelectronic component), respectively, and elevated pressures and/or temperatures may be applied to cause the contacting DB contacts and/or the contacting DB dielectrics to bond.

Direct bonding may provide significant advantages over conventional coupling techniques such as solder-based interconnects or wirebonds. Direct bonding interconnects may be capable of reliably conducting a higher current than other types of interconnects; for example, some conventional solder interconnects may form large volumes of brittle intermetallic compounds when current flows, and the maximum current provided through such interconnects may be constrained to mitigate mechanical failure. However, there are also some challenges that limit realization of the full potential of direct bonding.

One challenge of direct bonding resides in selection of materials to be used as DB contacts and DB dielectrics. Among the wide range of material choices available for DB dielectrics materials include organic dielectrics and inorganic dielectrics. For example, a dielectric material that includes silicon, carbon, nitrogen (e.g., in the form of silicon carbon nitride (SiCN)) may be particularly advantageous. Carbon content in SiCN may play an instrumental role in the hydrophilic nature of the surface of the DB dielectric. SiCN with relatively high carbon content (e.g., greater than 22-25%) may possess the least contact angle among the prospective dielectrics due the highest dangling bond density. As a result, conversion of molecular bonds to covalent bonds can be achieved, advantageously, at a much lower post-bond annealing temperature than their counterparts. Usually, a temperature below about 200°C will suffice. Post-bond annealing may serve two key purposes. One is conversion of dielectric molecular bonding to strong covalent bonds, and another one is copper-to-copper diffusion bonding when copper is used as a material for DB contacts. However, using conventional polycrystalline copper (PCC), a reliable copper-to-copper joint is formed only at temperatures around 300°C since diffusivity increases with temperature. Using fine-grain copper (FGC) as DB contact may help to slightly reduce the copper-to-copper joint formation temperature. However, FGC plating typically involves use of large amount of additives and these additives hinder diffusion at the interface. Hence, the advantages of lower post-bond annealing temperatures provided by SiCN dielectrics can be only realized if reliable copper-to-copper joints can also be formed at temperatures of or below about 200°C within 2-3 hours excluding ramp and cooling time periods. This is not currently feasible when PCC or FGC is used, but may be feasible when NTC is used as an alternative material of DB contacts.

As an alternative to PCC or FGC, NTC may be considered for low-temperature hybrid bond interconnects (HBI) due to having preferential <111> orientation of the grains, since copper diffusivity is about 1000 times higher in this orientation compared to other directions. Thus, the benefits of using SiCN as a DB dielectric with respect to low thermal budget bonding process flow may be realized when coupled with using NTC as a DB contact. Another advantage of NTC is its columnar microstructure, which is thermally stable and, hence, may help mitigate issues related to grain coarsening. Faster copper diffusivity in <111> direction and stable columnar microstructure make NTC a viable candidate for replacing PCC or FGC in direct bonding interconnects. Moreover, individual twins of NTC may advantageously act as grain boundary diffusion barriers and may help reduce or prevent void formation due to electromigration.

Accordingly, microelectronic assemblies, related devices and methods, with direct bonding using NTC are disclosed herein. Embodiments of a microelectronic assembly may include a first integrated circuit (IC) die having a first surface, an opposing second surface, and a third surface orthogonal to the first and second surfaces, the first IC die including conductive traces parallel to the first and second surfaces and exposed at the third surface; and a second IC die having a fourth surface with conductive contacts, wherein the conductive traces exposed at the third surface of the first IC die are electrically coupled to the conductive contacts at the fourth surface of the second IC die by metal-metal bonds including nanotwinned copper and dielectric-dielectric bonds. In some embodiments, the first IC die may be one of a plurality of first IC dies. In such embodiments, some of the plurality of first IC dies may include memory circuitry and some of the plurality of first IC dies may include compute circuitry.

Each of the structures, assemblies, packages, methods, devices, and systems of the present disclosure may have several innovative aspects, no single one of which is solely responsible for all the desirable attributes disclosed herein. Details of one or more implementations of the subject matter described in this specification are set forth in the description below and the accompanying drawings.

In the following detailed description, various aspects of the illustrative implementations may be described using terms commonly employed by those skilled in the art to convey the substance of their work to others skilled in the art.

The terms "circuit" and "circuitry" mean one or more passive and/or active electrical and/or electronic components that are arranged to cooperate with one another to provide a desired function. The terms also refer to analog circuitry, digital circuitry, hard wired circuitry, programmable circuitry, microcontroller circuitry and/or any other type of physical hardware electrical and/or electronic component.

The term "integrated circuit" means a circuit that is integrated into a monolithic semiconductor or analogous material.

In some embodiments, the IC dies disclosed herein may include substantially monocrystalline semiconductors, such as silicon or germanium, as a base material (e.g., substrate, body) on which integrated circuits are fabricated with traditional semiconductor processing methods. The semiconductor base material may include, for example, N-type pr P-type materials. Dies may include, for example, a crystalline base material formed using a bulk silicon (or other bulk semiconductor material) or a silicon-on-insulator (SOI) structure. In some other embodiments, the base material of one or more of the IC dies may include alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-N, group III-V, group II-VI, or group IV materials. In yet other embodiments, the base material may include compound semiconductors, for example, with a first sub-lattice of at least one element from group III of the periodic table (e.g., Al, Ga, In), and a second sub-lattice of at least one element of group V of the periodic table (e.g., P, As, Sb). In yet other embodiments, the base material may include an intrinsic IV or III-V semiconductor material or alloy, not intentionally doped with any electrically active impurity; in alternate embodiments, nominal impurity dopant levels may be present. In still other embodiments, dies may include a non-crystalline material, such as polymers; for example, the base material may include silica-filled epoxy. In other embodiments, the base material may include high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, the base material may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphide, and black phosphorus, each of which may possibly be doped with one or more of gallium, indium, aluminum, fluorine, boron, phosphorus, arsenic, nitrogen, tantalum, tungsten, and magnesium, etc. Although a few examples of the material for dies are described here, any material or structure that may serve as a foundation (e.g., base material) upon which IC circuits and structures as described herein may be built falls within the spirit and scope of the present disclosure.

Unless described otherwise, IC dies described herein include one or more IC structures (or, simply, "ICs") implementing (i.e., configured to perform) certain functionality. In one such example, the term "memory die" may be used to describe a die that includes one or more ICs implementing memory circuitry (e.g., ICs implementing one or more of memory devices, memory arrays, control logic configured to control the memory devices and arrays, etc.). In another such example, the term "compute die" may be used to describe a die that includes one or more ICs implementing logic/compute circuitry (e.g., ICs implementing one or more of I/O functions, arithmetic operations, pipelining of data, etc.).

In another example, the terms "package" and "IC package" are synonymous, as are the terms "die" and "IC die." Note that the terms "chip," "die," and "IC die" are used interchangeably herein.

The term "optical structure" includes arrangements of forms fabricated in ICs to receive, transform and/or transmit optical signals as described herein. It may include optical conductors such as waveguides, electromagnetic radiation sources such as lasers and light-emitting diodes (LEDs) and electro-optical devices such as photodetectors.

In various embodiments, any photonic IC (PIC) described herein may include a semiconductor material, for example, N-type or P-type materials. The PIC may include, for example, a crystalline base material formed using a bulk silicon (or other bulk semiconductor material) or a SOI structure (or, in general, a semiconductor-on-insulator structure). In some embodiments, the PIC may be formed using alternative materials, which may or may not be combined with silicon, that include, but are not limited to, lithium niobite, indium phosphide, silicon dioxide, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-N or group IV materials. In some embodiments, the PIC may include a non-crystalline material, such as polymers. In some embodiments, the PIC may be formed on a printed circuit board (PCB). In some embodiments, the PIC may be inhomogeneous, including a carrier material (such as glass or silicon carbide) as a base material with a thin semiconductor layer over which is an active side comprising transistors and like components. Although a few examples of the material for the PIC are described here, any material or structure that may serve as a foundation upon which the PIC may be built falls within the spirit and scope of the present disclosure.

The term "insulating" means "electrically insulating," the term "conducting" means "electrically conducting," unless otherwise specified. With reference to optical signals and/or devices, components and elements that operate on or using optical signals, the term "conducting" can also mean "optically conducting."

The terms "oxide," "carbide," "nitride," etc. refer to compounds containing, respectively, oxygen, carbon, nitrogen, etc.

The term "high-k dielectric" refers to a material having a higher dielectric constant than silicon oxide, while the term "low-k dielectric" refers to a material having a lower dielectric constant than silicon oxide.

The term "insulating material" or "insulator" (also called herein as "dielectric material" or "dielectric") refers to solid materials (and/or liquid materials that solidify after processing as described herein) that are substantially electrically nonconducting. They may include, as examples and not as limitations, organic polymers and plastics, and inorganic materials such as ionic crystals, porcelain, glass, silicon, silicon oxide, silicon carbide, silicon carbonitride, silicon nitride, and alumina or a combination thereof. They may include dielectric materials, high polarizability materials, and/or piezoelectric materials. They may be transparent or opaque without departing from the scope of the present disclosure. Further examples of insulating materials are underfills and molds or mold-like materials used in packaging applications, including for example, materials used in organic interposers, package supports and other such components.

In various embodiments, elements associated with an IC may include, for example, transistors, diodes, power sources, resistors, capacitors, inductors, sensors, transceivers, receivers, antennas, etc. In various embodiments, elements associated with an IC may include those that are monolithically integrated within an IC, mounted on an IC, or those connected to an IC. The ICs described herein may be either analog or digital and may be used in a number of applications, such as microprocessors, optoelectronics, logic blocks, audio amplifiers, etc., depending on the components associated with the IC. The ICs described herein may be employed in a single IC die or as part of a chipset for executing one or more related functions in a computer.

In various embodiments of the present disclosure, transistors described herein may be field-effect transistors (FETs), e.g., MOSFETs. In many embodiments, an FET is a four-terminal device. In silicon-on-insulator, or nanoribbon, or gate all-around (GAA) FET, the FET is a three-terminal device that includes source, drain, and gate terminals and uses electric field to control current flowing through the device. A FET typically includes a channel material, a source region and a drain regions provided in and/or over the channel material, and a gate stack that includes a gate electrode material, alternatively referred to as a "work function" material, provided over a portion of the channel material (the "channel portion") between the source and the drain regions, and optionally, also includes a gate dielectric material between the gate electrode material and the channel material.

In a general sense, an "interconnect" refers to any element that provides a physical connection between two other elements. For example, an electrical interconnect provides electrical connectivity between two electrical components, facilitating communication of electrical signals between them; an optical interconnect provides optical connectivity between two optical components, facilitating communication of optical signals between them. As used herein, both electrical interconnects and optical interconnects are included in the term "interconnect." The nature of the interconnect being described is to be understood herein with reference to the signal medium associated therewith. Thus, when used with reference to an electronic device, such as an IC that operates using electrical signals, the term "interconnect" describes any element formed of an electrically conductive material for providing electrical connectivity to one or more elements associated with the IC or/and between various such elements. In such cases, the term "interconnect" may refer to both conductive traces (also sometimes referred to as "lines," "wires," "metal lines" or "trenches") and conductive vias (also sometimes referred to as "vias" or "metal vias"). Sometimes, electrically conductive traces and vias may be referred to as "conductive traces" and "conductive vias", respectively, to highlight the fact that these elements include electrically conductive materials such as metals. Likewise, when used with reference to a device that operates on optical signals as well, such as a PIC, "interconnect" may also describe any element formed of a material that is optically conductive for providing optical connectivity to one or more elements associated with the PIC. In such cases, the term "interconnect" may refer to optical waveguides, including optical fiber, optical splitters, optical combiners, optical couplers, and optical vias.

The term "waveguide" refers to any structure that acts to guide the propagation of light from one location to another location typically through a substrate material such as silicon or glass. In various examples, waveguides can be formed from silicon, doped silicon, silicon nitride, glasses such as silica (e.g., silicon dioxide or SiO₂), borosilicate (e.g., 70-80 wt% SiO₂, 7-13 wt% of B₂O₃, 4-8 wt% Na₂O or K₂O, and 2-8 wt% of Al₂O₃) and so forth. Waveguides may be formed using various techniques including but not limited to forming waveguides in situ. For example, in some embodiments, waveguides may be formed in situ in glass using low temperature glass-to-glass bonding or by laser direct writing. Waveguides formed in situ may have lower loss characteristics.

The term "conductive trace" may be used to describe an electrically conductive element isolated by an insulating material. Within IC dies, such insulating material comprises interlayer low-k dielectric that is provided within the IC die. Within package substrates, and PCBs such insulating material includes organic materials such as Ajinomoto Buildup Film (ABF), polyimides, or epoxy resin. Such conductive lines are typically arranged in several levels, or several layers, of metallization stacks.

The term "conductive via" may be used to describe an electrically conductive element that interconnects two or more conductive lines of different levels of a metallization stack. To that end, a via may be provided substantially perpendicularly to the plane of an IC die/chip or a support structure over which an IC structure is provided and may interconnect two conductive lines in adjacent levels or two conductive lines in non-adjacent levels.

The term "package substrate" may be used to describe any substrate material that facilitates the packaging together of any collection of semiconductor dies and/or other electrical components such as passive electrical components. As used herein, a package substrate may be formed of any material including, but not limited to, insulating materials such as resin impregnated glass fibers (e.g., PCB or Printed Wiring Boards (PWB)), glass, ceramic, silicon, silicon carbide, etc. In addition, as used herein, a package substrate may refer to a substrate that includes buildup layers (e.g., ABF layers).

The term "metallization stack" may be used to refer to a stack of one or more interconnects for providing connectivity to different circuit components of an IC die/chip and/or a package substrate.

As used herein, the term "pitch" of interconnects refers to a center-to-center distance between adjacent interconnects.

It will be recognized that one more levels of underfill (e.g., organic polymer material such as benzotriazole, imidazole, polyimide, or epoxy) may be provided in an IC package described herein and may not be labeled in order to avoid cluttering the drawings. In various embodiments, the levels of underfill may include the same or different insulating materials. In some embodiments, the levels of underfill may include thermoset epoxies with silicon oxide particles; in some embodiments, the levels of underfill may include any suitable material that can perform underfill functions such as supporting the dies and reducing thermal stress on interconnects. In some embodiments, the choice of underfill material may be based on design considerations, such as form factor, size, stress, operating conditions, etc.; in other embodiments, the choice of underfill material may be based on material properties and processing conditions, such as cure temperature, glass transition temperature, viscosity and chemical resistance, among other factors; in some embodiments, the choice of underfill material may be based on both design and processing considerations.

In some embodiments, one or more levels of solder resist (e.g., epoxy liquid, liquid photoimageable polymers, dry film photoimageable polymers, acrylics, solvents) may be provided in an IC package described herein and may not be labeled or shown to avoid cluttering the drawings. Solder resist may be a liquid or dry film material including photoimageable polymers. In some embodiments, solder resist may be non-photoimageable.

The terms "substantially," "close," "approximately," "near," and "about," generally refer to being within +/- 20% of a target value (e.g., within +/- 5% or 10% of a target value) based on the context of a particular value as described herein or as known in the art.

Terms indicating orientation of various elements, e.g., "coplanar," "perpendicular," "orthogonal," "parallel," or any other angle between the elements, generally refer to being within +/- 5%-20% of a target value based on the context of a particular value as described herein or as known in the art.

The term "connected" means a direct connection (which may be one or more of a mechanical, electrical, and/or thermal connection) between the things that are connected, without any intermediary devices, while the term "coupled" means either a direct connection between the things that are connected, or an indirect connection through one or more passive or active intermediary devices.

The description uses the phrases "in an embodiment" or "in embodiments," which may each refer to one or more of the same or different embodiments.

Furthermore, the terms "comprising," "including," "having," and the like, as used with respect to embodiments of the present disclosure, are synonymous.

The disclosure may use perspective-based descriptions such as "above," "below," "top," "bottom," and "side"; such descriptions are used to facilitate the discussion and are not intended to restrict the application of disclosed embodiments.

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with one or both of the two layers or may have one or more intervening layers. In contrast, a first layer described to be "on" a second layer refers to a layer that is in direct contact with that second layer. Similarly, unless explicitly stated otherwise, one feature disposed between two features may be in direct contact with the adjacent features or may have one or more intervening layers.

The term "dispose" as used herein refers to position, location, placement, and/or arrangement rather than to any particular method of formation.

The term "between," when used with reference to measurement ranges, is inclusive of the ends of the measurement ranges.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). When used herein, the notation "A/B/C" means (A), (B), and/or (C).

Although certain elements may be referred to in the singular herein, such elements may include multiple sub-elements. For example," an electrically conductive material" may include one or more electrically conductive materials. In another example, "a dielectric material" may include one or more dielectric materials.

Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

The accompanying drawings are not necessarily drawn to scale.

In the drawings, same reference numerals refer to the same or analogous elements/materials shown so that, unless stated otherwise, explanations of an element/material with a given reference numeral provided in context of one of the drawings are applicable to other drawings where element/materials with the same reference numerals may be illustrated. Further, the singular and plural forms of the labels may be used with reference numerals to denote a single one and multiple ones respectively of the same or analogous type, species, or class of element.

Furthermore, in the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using, e.g., images of suitable characterization tools such as scanning electron microscopy (SEM) images, transmission electron microscope (TEM) images, or non-contact profilometer. In such images of real structures, possible processing and/or surface defects could also be visible, e.g., surface roughness, curvature or profile deviation, pit or scratches, not-perfectly straight edges of materials, tapered vias or other openings, inadvertent rounding of corners or variations in thicknesses of different material layers, occasional screw, edge, or combination dislocations within the crystalline region(s), and/or occasional dislocation defects of single atoms or clusters of atoms. There may be other defects not listed here but that are common within the field of device fabrication and/or packaging. Inspection of layout and mask data and reverse engineering of parts of a device to reconstruct the circuit using e.g., optical microscopy, TEM, SEM, and/or inspection of a cross-section of a device to detect the shape and the location of various device elements described herein using, e.g., Physical Failure Analysis (PFA) or Focused Ion Beam (FIB) would allow determination of presence of direct bonding using NTC as described herein.

Note that in the figures, various components (e.g., interconnects) are shown as aligned (e.g., at respective interfaces) merely for ease of illustration; in actuality, some or all of them may be misaligned. In addition, there may be other components, such as bond-pads, landing pads, metallization, etc. present in the assembly that are not shown in the figures to prevent cluttering. Further, the figures are intended to show relative arrangements of the components within their assemblies, and, in general, such assemblies may include other components that are not illustrated (e.g., various interfacial layers or various other components related to optical functionality, electrical connectivity, or thermal mitigation). For example, in some further embodiments, the assembly as shown in the figures may include more dies along with other electrical components. Additionally, although some components of the assemblies are illustrated in the figures as being planar rectangles or formed of rectangular solids, this is simply for ease of illustration, and embodiments of these assemblies may be curved, rounded, or otherwise irregularly shaped as dictated by and sometimes inevitable due to the manufacturing processes used to fabricate various components.

In the drawings, a particular number and arrangement of structures and components are presented for illustrative purposes and any desired number or arrangement of such structures and components may be present in various embodiments. To not clutter the drawings, if multiple instances of certain elements are illustrated, only some of the elements may be labeled with a reference sign.

Further, unless otherwise specified, the structures shown in the figures may take any suitable form or shape according to material properties, fabrication processes, and operating conditions.

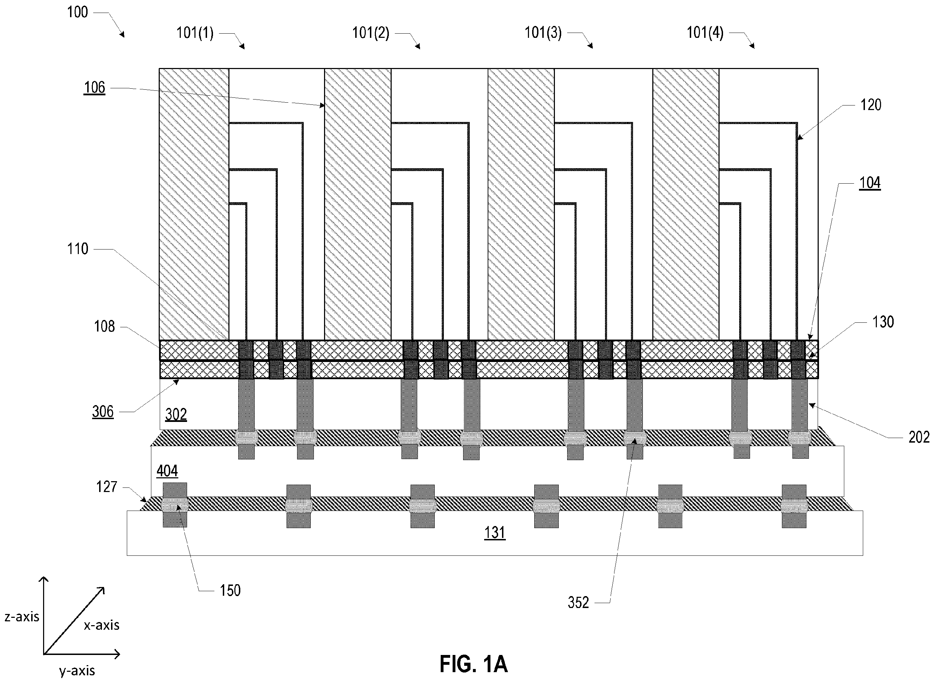

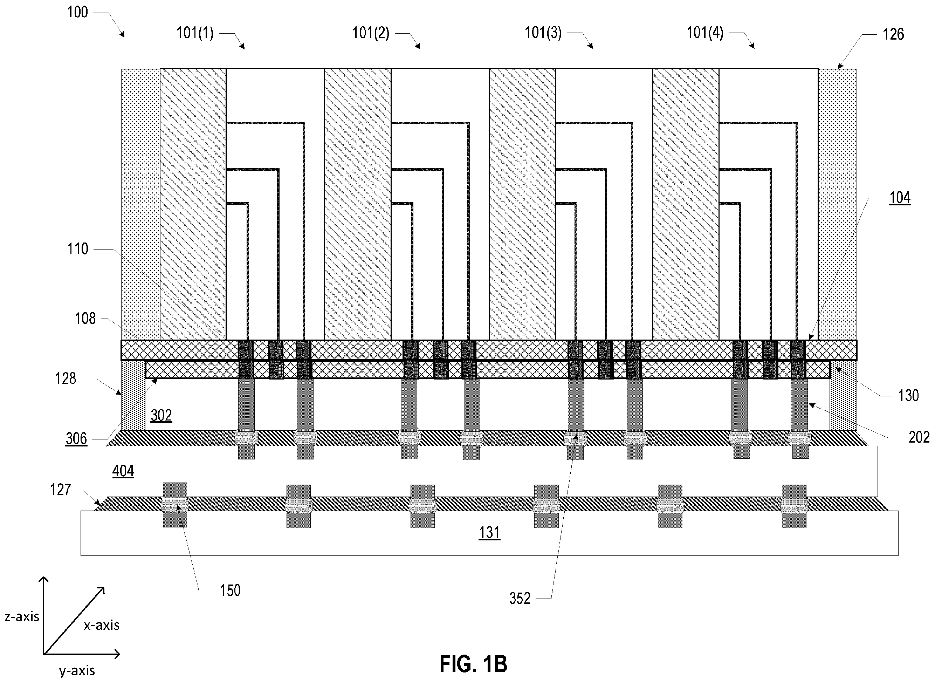

For convenience, if a collection of drawings designated with different letters are present (e.g., FIGS. 1A-1B), such a collection may be referred to herein without the letters (e.g., as "FIG. 1"). Similarly, if a collection of reference numerals designated with different letters are present (e.g., 101(1), 101(2), 101(3)), such a collection may be referred to herein without the letters (e.g., as "101").

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

### Example embodiments

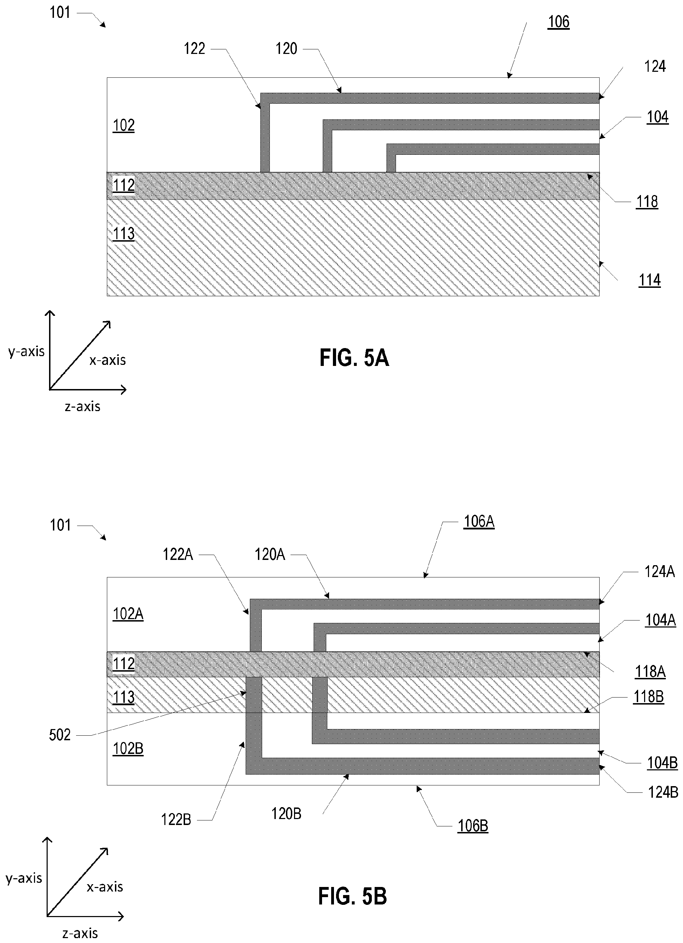

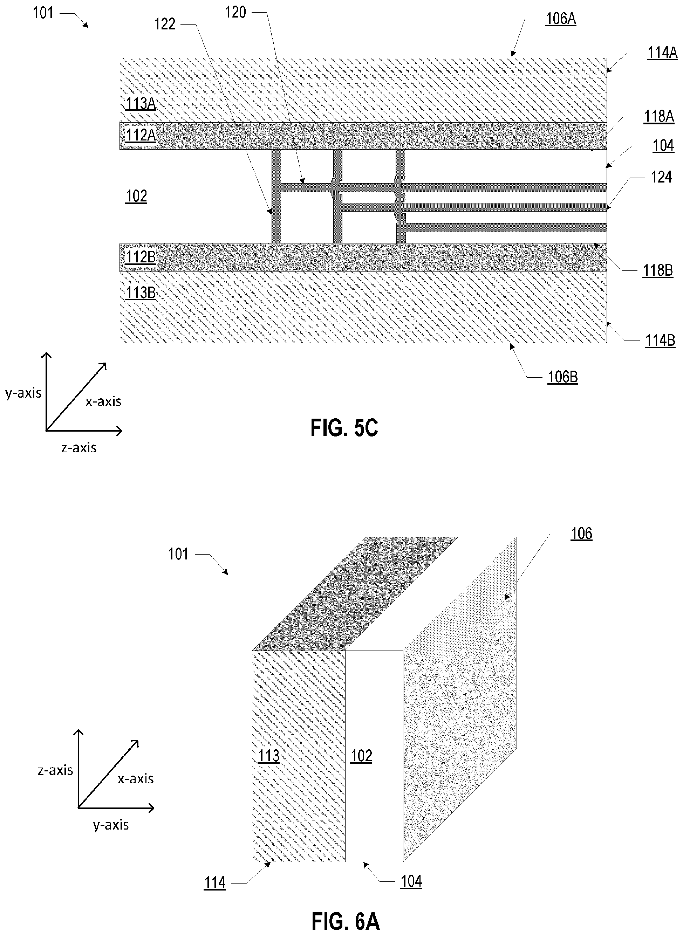

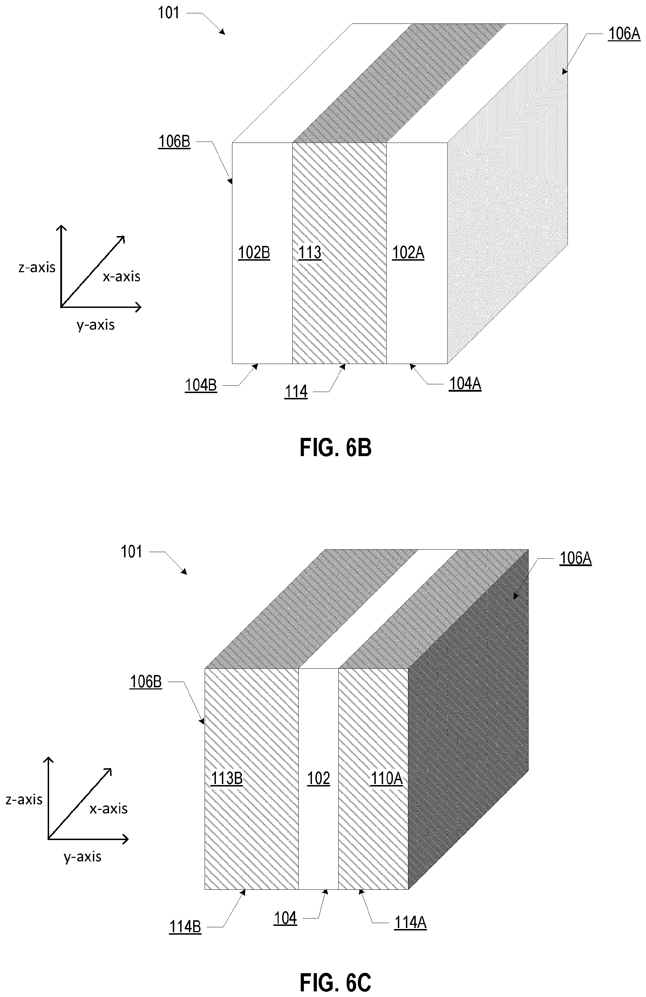

FIG. 1A is a schematic cross-sectional view of an example microelectronic assembly, in accordance with various embodiments. FIG. 1A shows microelectronic assembly 100 comprising a plurality of IC dies 101, for example, 101(1), 101(2), 101(3), and 101(4), bonded together at respective surfaces 106 (e.g., surfaces 106, as shown in FIGS. 5 and 6) and coupled to another IC die 302 by interconnects 130, also referred to herein as a "DB region". As described in relation to FIGS. 5 and 6, the IC dies 101 have conductive traces 120 exposed at a surface 104 that are electrically coupled to a surface 306 of IC die 302 by interconnects 130, which may include direct bonds or hybrid bonds.

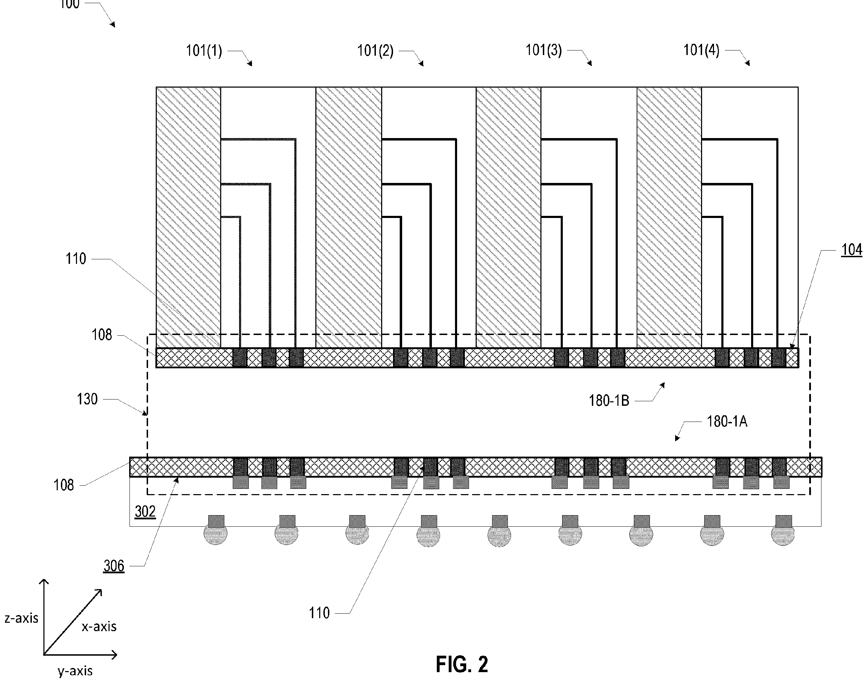

As illustrated in FIG. 2, the DB region 130 may include a DB interface 180-1A at the top surface of the IC die 302, with the DB interface 180-1A including a set of conductive DB contacts 110 and a DB dielectric 108 around the DB contacts 110 of the DB interface 180-1A. The DB region 130 may also include a DB interface 180-1B at the bottom surface of the IC dies 101 (e.g., IC dies 101(1), 101(2), 101(3), 101(4)), with the DB interface 180-1B including a set of DB contacts 110 and a DB dielectric 108 around the DB contacts 110 of the DB interface 180-1B. The DB contacts 110 of the DB interface 180-1A of the IC die 302 may substantially align with the DB contacts 110 of the DB interface 180-1B of the respective IC dies 101 so that, in the microelectronic assembly 100, the DB contacts 110 of the IC dies 101 are in contact with the DB contacts 110 of the IC die 302. In the microelectronic assembly 100 of FIG. 1, the DB interface 180-1A of the IC die 302 may be bonded (e.g., electrically and mechanically) with the DB interface 180-1B of the IC dies 101 to form the DB region 130 coupling the IC die 302 and the IC dies 101, as discussed further below. More generally, the DB region 130 disclosed herein may include two complementary DB interfaces 180 bonded together; for ease of illustration, many of the subsequent drawings may omit the identification of the DB interfaces 180 to improve the clarity of the drawings.

As described above, the term "direct bonding" is used to include metal-to-metal bonding techniques such as copper-to-copper bonding, or other techniques in which the DB contacts 110 of opposing DB interfaces 180 are brought into contact first, then subject to heat and compression. The term is also used to include hybrid bonding techniques such as techniques in which the DB dielectric 108 of opposing DB interfaces 180, possibly first subjected to prior surface activation, are brought into contact and then subjected to heat and sometimes compression, or techniques in which the DB contacts 110 and the DB dielectric 108 of opposing DB interfaces 180, possibly first subjected to prior surface activation, are brought into contact substantially simultaneously, then subject to heat and sometimes compression. In all such techniques, the DB contacts 110 and the DB dielectric 108 at one DB interface 180 are brought into contact with, respectively, the DB contacts 110 and the DB dielectric 108 at another DB interface 180, and elevated pressures and/or temperatures may be applied to cause the contacting DB contacts 110 and/or the contacting DB dielectrics 108 to bond. In some embodiments, this bond may be achieved without the use of intervening solder or an anisotropic conductive material, while in some other embodiments, a thin cap of solder may be used in a DB interconnect to accommodate planarity, and this solder may become an intermetallic compound in the DB region 130 during processing. In some embodiments, the DB dielectric 108 and the DB contacts 110 of a DB interface 180 may be manufactured using low-temperature deposition techniques (e.g., techniques in which deposition occurs at temperatures below 250 degrees Celsius, or below 200 degrees Celsius), such as low-temperature plasma-enhanced chemical vapor deposition (PECVD).

A DB dielectric 108 may include one or more dielectric materials, such as one or more inorganic dielectric materials or one or more organic materials. For example, a DB dielectric 108 may include an inorganic dielectric material, such as silicon, carbon, and nitrogen (e.g., in the form of silicon carbonitride); silicon and nitrogen (e.g., in the form of silicon nitride); silicon and oxygen (e.g., in the form of silicon oxide); and combinations thereof, as well as other such inorganic materials commonly used to fabricate semiconductor IC dies. In another example, a DB dielectric 108 may include an organic dielectric material, such as a curable polyimide.

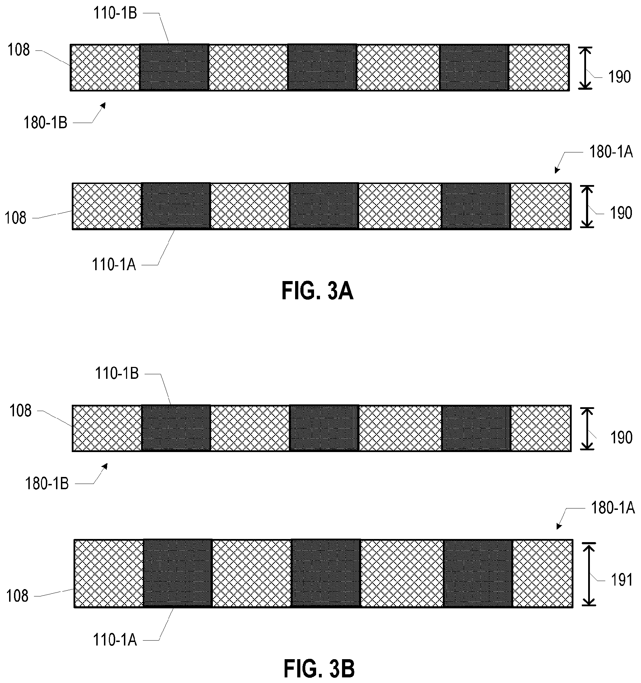

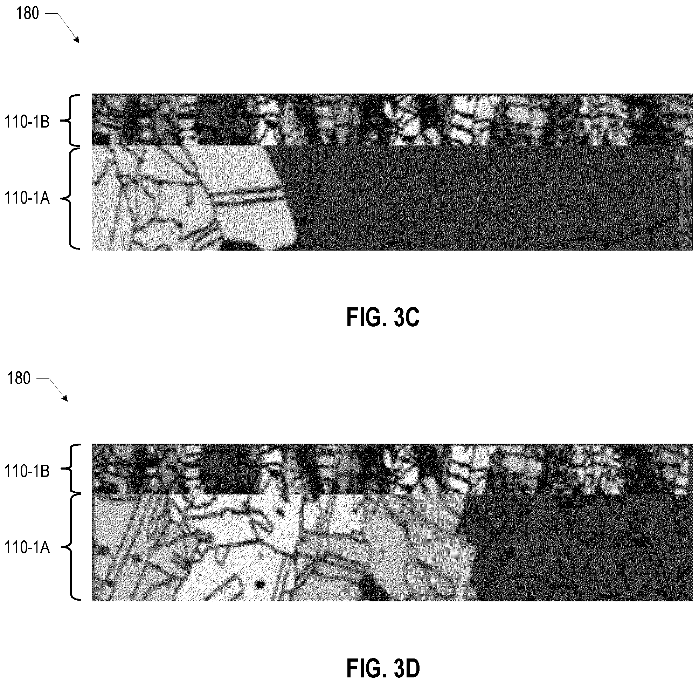

A DB contact 110 may include a pillar, a pad, or other structure. The DB contacts 110, although depicted in the accompanying drawings in the same manner at both DB interfaces 180 of a DB region 130, may have a same structure at both DB interfaces 180, or the DB contacts 110 at different DB interfaces 180 may have different structures. For example, in some embodiments, a DB contact 110 in one DB interface 180 may include a metal pillar (e.g., a copper pillar), and a complementary DB contact 110 in a complementary DB interface 180 may include a metal pad (e.g., a copper pad) recessed in a dielectric. A material of a DB contact 110 may include NTC, may include NTC and PCC, or may include NTC and FGC, as described in detail below with reference to FIG. 3.

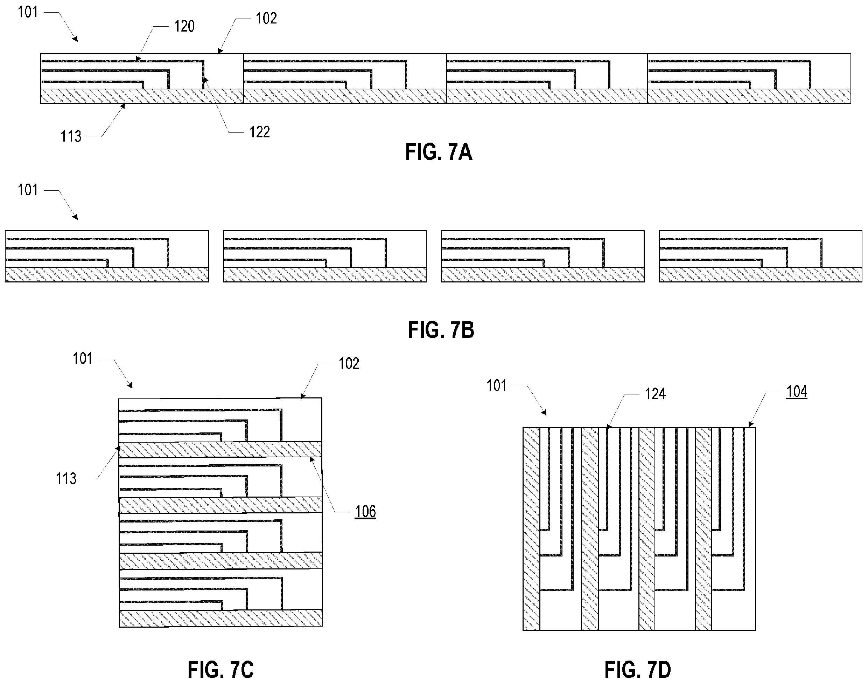

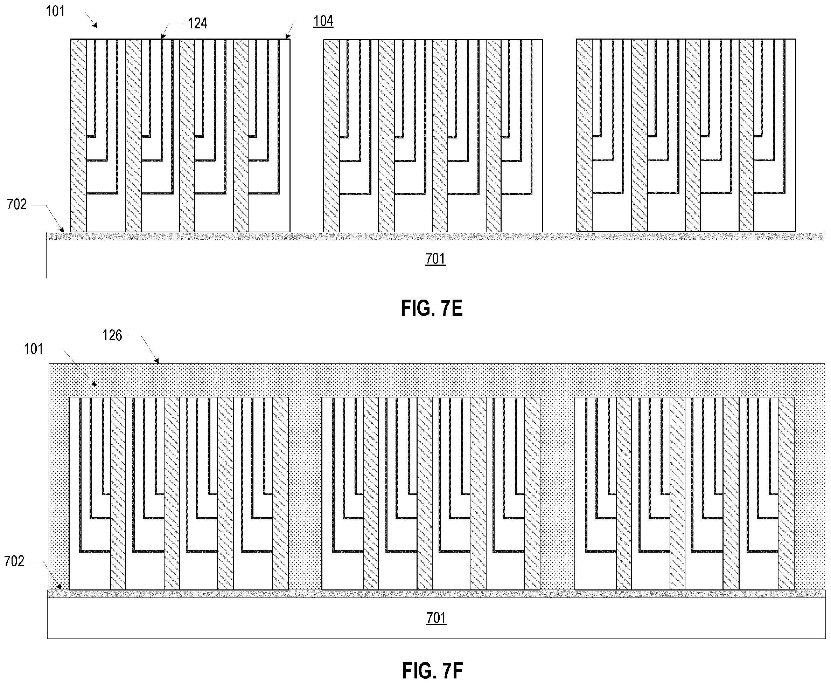

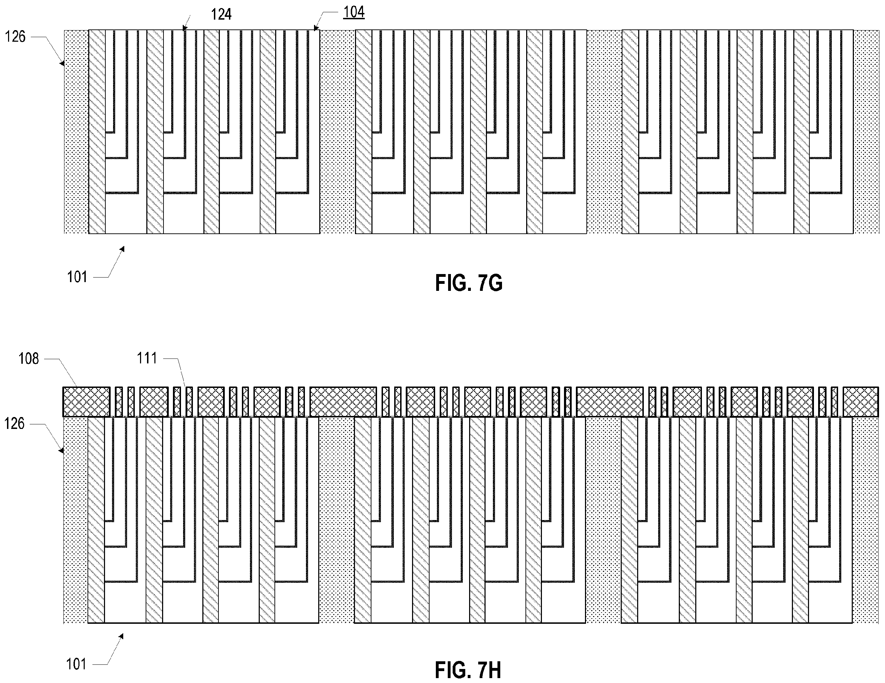

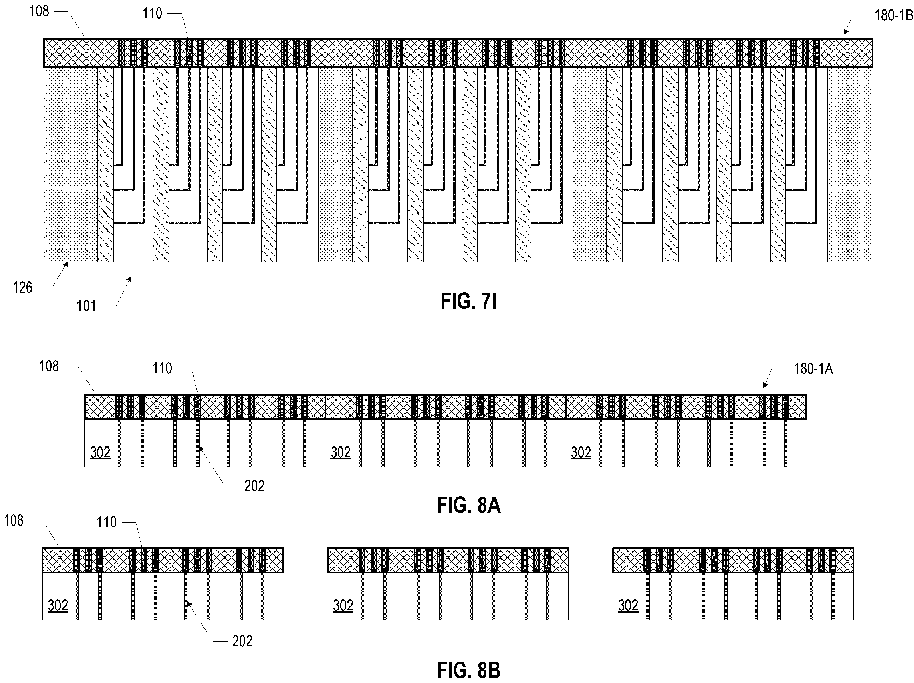

Returning to FIG. 1A, IC dies 101(1), 101(2), 101(3), and 101(4) may be stacked and bonded together, for example, by oxide-oxide bond or inorganic dielectric-inorganic dielectric bonds. The stacked and bonded IC dies 101 may be rotated 90 degrees and electrically coupled to IC die 302, as described below with reference to FIG. 7. Stacking and bonding IC dies 101 prior to coupling with IC die 302 may allow for IC dies 101 to be more easily handled during assembly operations. Any suitable number of IC dies 101 may be stacked and bonded together, for example, between 2 and 100 IC dies. In various embodiments, IC dies 101 may be arranged such that a gap or a cooling apparatus is included between some of the adjacent IC dies 101 (not shown). Although FIG. 1 shows IC dies 101 having a particular stacked arrangement (e.g., all facing a same direction), in some embodiments, one or more of IC dies 101 may have a different stacked arrangement (e.g., one or more IC dies 101 may be inverted to face an opposite direction). Further, although FIG. 1 includes IC dies 101 of FIG. 5A, a stack of IC dies 101 may include any IC dies 101 of FIGS. 5A-5C.

IC dies 101 may include any suitable circuitry. In some embodiments, IC dies 101 may include compute circuitry, graphics processing circuitry, and/or memory circuitry, and IC die 302 may include a network on chip circuitry, conductively coupling the array of IC dies 101. For example, in some embodiments, IC dies 101(1), 101(3) may include memory circuitry, IC dies 101(2), 101(4) may include compute circuitry, and IC die 302 may include a network on chip circuitry, conductively coupling the array of IC dies 101. In some embodiments, IC dies 101 may include capacitors and/or inductors. Any suitable configuration of circuitry may be provided in microelectronic assembly 100 among IC dies 101 and IC die 302 as desired and based on particular needs.

The microelectronic assembly 100 may further include a package substrate 404. The package substrate 404 may include an insulating material (e.g., a dielectric material formed in multiple layers, as known in the art) and one or more conductive pathways to route power, ground, and signals through the dielectric material (e.g., including conductive traces and/or conductive vias, as shown). In some embodiments, the insulating material of the package substrate 404 may be a dielectric material, such as an organic dielectric material, a fire retardant grade 4 material (FR-4), BT resin, polyimide materials, glass reinforced epoxy matrix materials, organic dielectrics with inorganic fillers or low-k and ultra low-k dielectric (e.g., carbon-doped dielectrics, fluorine-doped dielectrics, porous dielectrics, and organic polymeric dielectrics). In particular, when the package substrate 404 is formed using standard printed circuit board (PCB) processes, the package substrate 404 may include FR-4, and the conductive pathways in the package substrate 404 may be formed by patterned sheets of copper separated by build-up layers of the FR-4. The conductive pathways in the package substrate 404 may be bordered by liner materials, such as adhesion liners and/or barrier liners, as suitable. In some embodiments, the package substrate 404 may be formed using a lithographically defined via packaging process. In some embodiments, the package substrate 404 may be manufactured using standard organic package manufacturing processes, and thus the package substrate 404 may take the form of an organic package. In some embodiments, the package substrate 404 may be a set of redistribution layers formed on a panel carrier by laminating or spinning on a dielectric material, and creating conductive vias and lines by laser drilling and plating. In some embodiments, the package substrate 404 may be formed on a removable carrier using any suitable technique, such as a redistribution layer technique. Any method known in the art for fabrication of the package substrate 404 may be used, and for the sake of brevity, such methods will not be discussed in further detail herein.

In various embodiments, IC die 302 may include an interposer with conductive traces such as through-substrate vias (TSVs) 202, as shown, to enable conductive coupling of IC die 101 with other IC dies and/or package substrates, and IC die 302 may not have any active circuitry therein. In other embodiments, IC die 302 may include active circuitry. In many embodiments, IC dies 101 may be conductively coupled by conductive pathways in IC die 302. For example, IC die 302 may include a network on chip, interconnecting compute circuitry of IC dies 101 together. In various embodiments, IC die 101 may be conductively coupled to IC die 302 by interconnects 130, which may include direct bonds or hybrid bonds. In many embodiments, IC die 302 may be large-sized, for example, as large as a conventional reticle, which can be approximately 850 square millimeters in footprint area. IC die 302 may be coupled to the package substrate 404 by interconnects 352. In some embodiments, the interconnects 352 disclosed herein may have a pitch between about 20 microns and 200 microns. The interconnects 352 disclosed herein may take any suitable form. When interconnects are described herein, a surface of a first die may include a first set of conductive contacts, and a surface of a second die or a package substrate may include a second set of conductive contacts. One or more conductive contacts of the first set may then be electrically and mechanically coupled to some of the conductive contacts of the second set by the interconnects. In some embodiments, a set of interconnects 352 may include solder (e.g., solder bumps or balls that are subject to a thermal reflow to form the interconnects 352). The interconnects 352 that include solder may include any appropriate solder material, such as lead/tin, tin/bismuth, eutectic tin/silver, ternary tin/silver/copper, eutectic tin/copper, tin/nickel/copper, tin/bismuth/copper, tin/indium/copper, tin/zinc/indium/bismuth, or other alloys. In some embodiments, a set of interconnects 352 may include an anisotropic conductive material, such as an anisotropic conductive film or an anisotropic conductive paste. An anisotropic conductive material may include conductive materials dispersed in a non-conductive material. In some embodiments, an anisotropic conductive material may include microscopic conductive particles embedded in a binder or a thermoset adhesive film (e.g., a thermoset biphenyl-type epoxy resin, or an acrylic-based material). In some embodiments, the conductive particles may include a polymer and/or one or more metals (e.g., nickel or gold). For example, the conductive particles may include nickel-coated gold or silver-coated copper that is in turn coated with a polymer. In another example, the conductive particles may include nickel. When an anisotropic conductive material is uncompressed, there may be no conductive pathway from one side of the material to the other. However, when the anisotropic conductive material is adequately compressed (e.g., by conductive contacts on either side of the anisotropic conductive material), the conductive materials near the region of compression may contact each other so as to form a conductive pathway from one side of the film to the other in the region of compression.

In some embodiments, some of the interconnects 352, 150 in a microelectronic assembly or an IC package as described herein may be metal-to-metal interconnects (e.g., copper-to-copper interconnects, or plated interconnects). In such embodiments, the conductive contacts on either side of the interconnect may be bonded together (e.g., under elevated pressure and/or temperature) without the use of intervening solder or an anisotropic conductive material. In some metal-to-metal interconnects, a dielectric material (e.g., silicon oxide, silicon nitride, silicon carbide) may be present between the metals bonded together (e.g., between copper pads or posts that provide the associated conductive contacts). In some embodiments, one side of an interconnect may include a metal pillar (e.g., a copper pillar), and the other side of the interconnect may include a metal contact (e.g., a copper contact) recessed in a dielectric. In some embodiments, a metal-to-metal interconnect (e.g., a copper-to-copper interconnect) may include a noble metal (e.g., gold) or a metal whose oxides are conductive (e.g., silver). In some embodiments, a metal-to-metal interconnect may include metal nanostructures (e.g., nanorods) that may have a reduced melting point. Metal-to-metal interconnects may be capable of reliably conducting a higher current than other types of interconnects; for example, some solder interconnects may form brittle intermetallic compounds when current flows, and the maximum current provided through such interconnects may be constrained to mitigate mechanical failure.

In some embodiments, a thin cap of solder may be used in a metal-to-metal interconnect to accommodate planarity, and this solder may become an intermetallic compound during processing. In some embodiments, the solder used in some of the interconnects may have a higher melting point than the solder included in other of the interconnects. For example, when the interconnects in an IC package are formed before other interconnects, solder-based interconnects formed first may use a higher-temperature solder (e.g., with a melting point above 200 degrees Celsius), while the interconnects formed second may use a lower-temperature solder (e.g., with a melting point below 200 degrees Celsius). In some embodiments, a higher-temperature solder may include tin; tin and gold; or tin, silver, and copper (e.g., 96.5 % tin, 3% silver, and 0.5% copper). In some embodiments, a lower-temperature solder may include tin and bismuth (e.g., eutectic tin bismuth), tin, silver, bismuth, indium, indium and tin, or gallium.

In some embodiments, the microelectronic assembly 100 may also include an underfill material 127. In some embodiments, the underfill material 127 may extend between a bottom surface of IC die 302 and a top surface of the package substrate 404 around the associated interconnects 352. The underfill material 127 may be an insulating material, such as an appropriate epoxy material. In some embodiments, the underfill material 127 may include a capillary underfill, non-conductive film (NCF), or molded underfill. In some embodiments, the underfill material 127 may include an epoxy flux that assists with soldering IC die 302 to the package substrate 404 when forming the interconnects 352, and then polymerizes and encapsulates the interconnects 352. The underfill material 127 may be selected to have a coefficient of thermal expansion (CTE) that may mitigate or minimize the stress between IC die 302 and the package substrate 404 arising from uneven thermal expansion in the microelectronic assembly 100.

In some embodiments, the microelectronic assembly 100 may also include a circuit board 131. The package substrate 404 may be coupled to the circuit board 131 by interconnects 150 at the bottom surface of the package substrate 404. The interconnects 150 may be any suitable interconnects, including solder balls for a ball grid array arrangement, pins in a pin grid array arrangement or lands in a land grid array arrangement. In some embodiments, the interconnects 150 disclosed herein may have a pitch between about 50 microns and 100 microns. The circuit board 131 may be a motherboard, for example, and may have other components attached to it. The circuit board 131 may include conductive pathways and other conductive contacts for routing power, ground, and signals through the circuit board, as known in the art. In some embodiments, the circuit board 131 may include a power source (not shown), and the package substrate 404 is electrically coupled to the input power rail on the circuit board 131. In some embodiments, the interconnects 150 may not couple the package substrate 404 to a circuit board 131, but may instead couple the package substrate 404 to another IC package, an interposer, or any other suitable component.

FIG. 1B is a schematic cross-sectional view of an example microelectronic assembly, in accordance with various embodiments. The embodiment shown in the figure is substantially similar to that of FIG. 1A, except that microelectronic assembly 100 further includes an insulating material 126 and/or a gap fill material 128. The insulating material 126 may extend around IC dies 101 on the IC die 302. The insulating material 126 may be a mold material, such as an appropriate epoxy material or a low stress mold material. The insulating material 126 may be selected to have a coefficient of thermal expansion (CTE) that may mitigate or minimize the stress between the IC dies 101 and the IC die 302 arising from uneven thermal expansion in the microelectronic assembly 100. In some embodiments, the insulating material 126 used in a microelectronic assembly 100 may be selected at least in part for its structural properties. For example, one or more insulating materials 126 used in a microelectronic assembly 100 may provide mechanical support to the microelectronic assembly 100 to reduce or prevent warpage. In some embodiments, the insulating material 126 used in a microelectronic assembly 100 may be selected at least in part for its thermal properties. For example, one or more insulating materials 126 used in a microelectronic assembly 100 may have low thermal conductivity (e.g., conventional mold compounds) to retard heat transfer, or may have high thermal conductivity (e.g., mold materials including metal or ceramic particles with high thermal conductivity, such as copper, silver, diamond, silicon carbide, aluminum nitride, and boron nitride, among others) to facilitate heat transfer. The gap fill material 128 may extend around IC die 302 below IC dies 101. The gap fill material 128 may be any suitable fill material, for example, silicon and oxygen in the form of silicon oxide. Although FIG. 1B illustrates a DB dielectric 108 between the insulating material 126 and the gap fill material 128, in some embodiments, there is no DB dielectric 108 between the insulating material 126 and the gap fill material 128.

FIG. 3A illustrates an example DB interface 180 (e.g., DB interface 180-1A, which may be part of IC die 302 and DB interface 180-1B, which may be part of IC die 101) that includes DB dielectric 108 around DB contacts 110. The DB contacts 110-1A and 110-1B may both include NTC. The DB dielectric 108 may include an organic dielectric material or an inorganic dielectric material, as described above with reference to FIG. 2. A thickness 190 (e.g., z-dimension) of the DB interfaces 180 with DB contacts 110-1A and 110-1B including NTC may be between 50 nanometers and 300 nanometers. An overall thickness of an interconnect 130 (e.g., the DB region 130 including DB interfaces 180-1A, 180-1B), where a material of DB contacts 110-1A and 110-1B is NTC (e.g., as shown in FIG. 3A) may be between 100 nanometers and 600 nanometers.

FIG. 3B illustrates an example DB interface 180 (e.g., DB interface 180-1A, which may be part of IC die 302 and DB interface 180-1B, which may be part of IC die 101) that includes DB dielectric 108 around DB contacts 110. The DB contacts 110-1A may include PCC or FGC, and DB contacts 110-1B may include NTC. The DB dielectric 108 may include an organic dielectric material or an inorganic dielectric material, as described above with reference to FIG. 2. A thickness 191 (e.g., z-dimension) of the DB interface 180-1A with DB contacts 110-1A including PCC or FGC may be between 50 nanometers and 5 microns. An overall thickness of an interconnect 130 (e.g., the DB region 130 including DB interfaces 180-1A, 180-1B), where a material of DB contacts 110-1A is PCC or FGC and a material of DB contacts 110-1B is NTC (e.g., as shown in FIG. 3B) may be between 100 nanometers and 5.3 microns.

Different microstructures of NTC compared to PCC or FGC would be clearly visible from images of EBSD or other characterization techniques, as is illustrated with FIG. 3C, showing an interface between a DB contacts 110-1A and 110-1B, where a material of DB contact 110-1A includes PCC and a material of DB contact 110-1B includes NTC, or as is illustrated with FIG. 3D, showing an interface where a material of DB contact 110-1A includes FGC and a material of DB contact 110-1B includes NTC. FIGS. 3C and 3D illustrate that NTC has a columnar microstructure in that the grains have a columnar shape (i.e., the length of the grains is greater than the width of the grains) where different columnar grains are substantially oriented along one direction, while the grains of PCC or FGC do not have a columnar shape (i.e., on average, their length is about the same as their widths) and are not oriented along any particular direction. Having a material such as NTC may be advantageous in terms of retaining the columnar microstructure and relatively high copper diffusivity. In some embodiments, microstructures of NTC may be different in terms of different crystallographic orientations of their grains as compared to PCC and FGC. For example, a material with at least about 50% of grains having a <111> orientation may be characteristic of NTC. Having NTC that has majority of grains with <111> orientation as an electrically conductive material at the DB interface 180 may be advantageous in terms of faster copper diffusivity in <111> direction. A material with less than about 40% of the grains having a <111> orientation may be characteristic of PCC or FGC. Similarly, a material with grains having a substantially random orientation (e.g., grains may have about equal distribution of different crystallographic orientations, such as <111>, <101>, and <001> orientations) may also be characteristic of materials such as PCC or FGC and drastically different from NTC. Further, microstructures of the materials (e.g., NTC vs PCC and FGC) may be different in terms of different average dimensions of their grains. For example, in some embodiments, an average grain dimension of grains may be at least about 2.5 micron (e.g., at least about 3 micron, between about 3 and 6 micron, or between about 5 and 6 micron), which may be characteristic of PCC. In some embodiments, an average grain dimension of grains may be less than about 3 micron (e.g., less than about 2.5 micron, between about 1 and 3 micron, or between about 2 and 3 micron), which may be characteristic of FGC. In some embodiments, an average grain length (i.e., the longest dimension) of grains may be at least about 1 micron (e.g., between about 1 and 3 micron or between about 1 and 2 micron), while an average grain width (i.e., a dimension perpendicular to the length), may be smaller than the length, e.g., at least 20% smaller or at least 50% smaller, which may be characteristic of NTC.

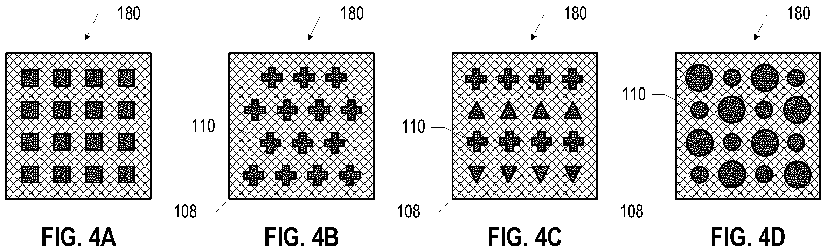

FIGS. 4A-4D are top views of various arrangements of DB contacts 110 in a DB dielectric 108 of a DB interface 180. The footprints of the DB contacts 110 in a DB interface 180 may have any desired shape, and multiple DB contacts 110 may be arranged within a DB interface 180 in any desired manner (e.g., by the use of lithographic patterning techniques to form the DB contacts 110). In the embodiment of FIG. 4A, the DB contacts 110 have rectangular (e.g., square) footprints and are arranged in a rectangular array. In the embodiment of FIG. 4B, the DB contacts 110 have cross-shaped footprints and are arranged in a triangular array. In the embodiment of FIG. 4C, the DB contacts 110 are arranged in a rectangular array, and alternating rows of the DB contacts 110 have cross-shaped footprints and triangular footprints. In the embodiment of FIG. 4D, the DB contacts 110 are arranged in a rectangular array, the DB contacts 110 have circular footprints, and the diameters of the footprints of the DB contacts 110 vary in a checkerboard pattern. DB contacts 110 included in a DB interface 180 may have any suitable combination of these and other footprint shapes, sizes, and arrangements (e.g., hexagonal arrays, oval footprints, etc.). In some particular embodiments, DB contacts 110 in a DB interface 180 may have footprints shaped as convex polygons (e.g., squares, rectangles, octagons, cross shapes, etc.) or circles.

FIG. 5A is a schematic cross-sectional view of an example IC die 101, in accordance with various embodiments. IC die 101 includes, in the embodiment shown, a metallization stack 102 having a surface 104 orthogonal to another surface 106. In various embodiments, surfaces 104 and 106 may be planarized. Generally, an IC die, that is different from IC die 101, does not have planarized edges along the thickness, e.g., the vertical surfaces corresponding to surface 104 would be rough, having undergone a dicing operation when the IC die is singulated from a wafer. In contrast, surface 104 of IC die 101 may be flat and planar with surface roughness less than 10 Angstroms and total thickness variation (TTV) across surface 104 of less than 3 microns. As shown in FIG. 1, when included in a microelectronic assembly 100, the IC die 101 is rotated 90 degrees such that the orientation of a thickness (e.g., z-dimension) and a width (e.g., y-dimension) are switched, as shown in FIG. 5.

Metallization stack 102 may be on a substrate 113 (e.g., at an interface 118). Interface 118 may be orthogonal to surface 104 and parallel to surface 106 (e.g., in the xz-plane). It is to be understood that while the interface 118 is in the xz-plane, the interface 118 may not be exactly planar. The substrate 113 may further include active region 112. In some embodiments, active region 112 may include transistors, diodes, and other active circuitry and may be proximate to interface 118. In some other embodiments, active region 112 may be absent, or alternatively, transistors, diodes, and other active circuitry may be absent in active region 112. Substrate 113 may have a surface 114 that may be coplanar with surface 104. In some embodiments, substrate 113 may include a semiconductor material as listed above in the previous subsection. In other embodiments, substrate 113 may include glass, ceramic, or other materials that may be suitable for creating functional elements of an IC.

In various embodiments, metallization stack 102 may include a dielectric material, or a plurality of layers of dielectric material, and conductive traces 120 through the dielectric material. The conductive traces 120 may be parallel to surface 106 such that conductive traces 120 are orthogonal to surface 104. In some embodiments, a dielectric material of the metallization stack 102 may include silicon oxide; in other embodiments, the dielectric material of the metallization stack 102 may include any suitable dielectric material used as interlayer dielectrics (ILD) in a typical semiconductor IC die and as described above in the previous subsection. Conductive traces 120 may include a conductive metal, such as copper, in many embodiments. In some embodiments, there may be between 2 and 6 layers of conductive traces 120 in the plurality of layers of dielectric material. Conductive vias 122 through the dielectric material may conductively connect conductive traces 120 to active circuitry in active region 112. Conductive vias 122 are orthogonal to conductive traces 120. Conductive traces 120 may extend up to surface 104 such that portions of conductive traces 120 are exposed on surface 104; such exposed portions may form bonding-portions 124. In various embodiments, there may be several conductive traces 120 between interface 118 and surface 106. One or more of the conductive traces 120 may be exposed on surface 104 as bonding-portions 124. In some embodiments, a linear dimension (e.g., length, width, or diagonal) of the largest bonding-portion 124 may be less than 5 microns. In some embodiments, bonding-portions 124 may be spaced apart with a pitch of less than 9 microns. A DB contact 110, as shown in FIG. 1, may be formed on a bonding-portion 124 at the surface 104.

FIG. 5B is a schematic cross-sectional view of another example IC die 101, in accordance with various embodiments. In some embodiments, IC die 101 may include metallization stacks 102A and 102B on either side of substrate 113. Metallization stack 102A may share interface 118A with substrate 113, and metallization stack 102B may share interface 118B with substrate 113. In some embodiments, as shown in FIG. 5B, active region 112 may be proximate to interface 118A; in other embodiments, active region 112 may be proximate to interface 118B. Conductive traces 120A and conductive vias 122A may be in metallization stack 102A. Conductive traces 120B and conductive vias 122B may be in metallization stack 102B. In some embodiments, conductive traces 120A may be configured to route signals, whereas conductive traces 120B may be configured to route power and ground to active region 112. In such embodiments, conductive traces 120B may be thicker than conductive traces 120A (i.e., conductive traces 120A may be thinner than conductive traces 120B). In other embodiments, conductive traces 120A and conductive traces 120B may be configured to route signals, power, and ground without any differentiation between them. In such embodiments, conductive traces 120A and 120B may be of similar thickness. Through-silicon vias (TSVs) 502 through substrate 113 may enable conductive pathways between conductive traces 120A and 120B and/or active region 112 and conductive traces 120B. In some embodiments, TSVs 502 may be through active region 112 (not shown).

FIG. 5C is a schematic cross-sectional view of yet another example IC die 10, in accordance with various embodiments. In some embodiments, IC die 101 may include substrates 113A and 113B on either side of metallization stack 102. Substrate 113A may include surface 106A and substrate 113B may include surface 106B. Substrate 113A may share interface 118A with metallization stack 102 and substrate 113B may share interface 118B with metallization stack 102. Substrate 113A may include active region 112A and substrate 113B may include active region 112B. Active regions 112A and 112B may be adjacent to metallization stack 102 at respective interfaces 118A and 118B. Substrates 113A and 113B may have respective surfaces 114A and 114B that may be coplanar with surface 104. Metallization stack 102 may include a dielectric material and conductive traces 120 and conductive vias 122 through the dielectric material. Conductive vias 122 are orthogonal to conductive traces 120. The conductive traces 120 may be parallel to interfaces 118A and 118B such that conductive traces 120 are orthogonal to surface 104. Conductive vias 122 through the dielectric material may conductively connect conductive traces 120 to active circuitry in active regions 112A and 112B. Conductive vias 122 and conductive traces 120 may include any one or more conductive materials, such as copper (e.g., PCC or FGC), manganese, titanium, gold, silver, palladium, nickel, copper and aluminum (e.g., in the form of a copper aluminum alloy), tantalum (e.g., tantalum metal, or tantalum and nitrogen in the form of tantalum nitride), cobalt, cobalt and iron (e.g., in the form of a cobalt iron alloy), or any alloys of any of the foregoing (e.g., copper, manganese, and nickel in the form of manganin). One or more conductive vias 122 may further extend through the active regions 112A and/or 112B (not shown). In some embodiments, conductive traces 120 and conductive vias 122 may be configured to route signals between active regions 112A and 112B. In some embodiments, conductive traces 120 and conductive vias 122 may be configured to route power and ground between active regions 112A and 112B. In such embodiments, conductive traces 120 may be thicker (i.e., similar to conductive traces 120B in FIG. 5B). In some embodiments, conductive traces 120 may have a linear dimension (e.g., x-dimension and z-dimension) between 1 micron and 10 microns. Conductive traces 120 may extend up to surface 104 such that portions of conductive traces 120 are exposed on surface 104; such exposed portions may form bonding-portions 124.

FIG. 6A is a simplified perspective view of an IC die 101. FIG. 6A shows IC die 101 of FIG. 5A that has been rotated 90 degrees so that the surfaces 114 and 104 are positioned at the bottom and the surface 106 is positioned laterally. IC die 101 may include substrate 113, active region 112, and metallization stack 102. IC die 101 may have any suitable dimensions. In various embodiments, IC die 101 may have a thickness (e.g., z-dimension) between 1 millimeter and 5 millimeters, a width (e.g., y-dimension) between 10 microns and 800 microns, and a length (e.g., x-dimension) between 10 millimeters and 33 millimeters. Substrate 113 of IC die 101 may be thinned so that IC die 101 has a desired width.

FIG. 6B is a simplified perspective view of an IC die 101. FIG. 6B shows IC die 101 of FIG. 5B that has been rotated 90 degrees so that the surfaces 114, 104A, and 104B are positioned at the bottom and the surfaces 106A, 106B are positioned laterally. IC die 101 may include substrate 113, active region 112, and metallization stacks 102A, 102B. IC die 101 may have any suitable dimensions, including dimensions as described above with reference to FIG. 6A. Substrate 113 may have any suitable width (e.g., y-dimension). In various embodiments, substrate 113 may have a width between less than 1 micron and 50 microns. In some embodiments, substrate 113 may be almost entirely removed such that TSVs 502 (not shown) may be very thin (e.g., having a thickness of less than 1 micron) and may provide direct contact to a transistor source/drain in active region 112.

FIG. 6C is a simplified perspective view of an IC die 101. FIG. 6C shows IC die 101 of FIG. 5C that has been rotated 90 degrees so that the surfaces 114A, 114B, and 104 are positioned at the bottom and the surfaces 106A, 106B are positioned laterally. IC die 101 may include substrates 113A, 113B, active regions 112A, 112B, and metallization stack 102. IC die 101 may have any suitable dimensions, including dimensions as described above with reference to FIG. 6A. In various embodiments, IC die 101 may have a width (e.g., y-dimension) between 20 microns and 1,600 microns.

In various embodiments, any of the features discussed with reference to any of FIGS. 1-6 herein may be combined with any other features to form a package with one or more IC dies as described herein, for example, to form a modified IC die 101 or a modified microelectronic assembly 100. Some such combinations are described above, but, in various embodiments, further combinations and modifications are possible. Various different embodiments described in different figures may be combined suitably based on particular needs within the broad scope of the embodiments.

### Example methods

FIGS. 7A-7I are schematic cross-sectional views of various stages of manufacture of an example portion of a microelectronic assembly, in accordance with various embodiments. FIG. 7A illustrates a wafer including IC dies 101 having substrate 113 and metallization stack 102 with conductive traces 120 and conductive vias 122. IC dies 101 may include any suitable circuitry such as memory circuitry or compute circuitry. FIG. 7B illustrates the wafer of FIG. 7A subsequent to dicing into IC dies 101. The wafer of FIG. 7A may be subjected to particle-lite dicing to reduce the amount of particles generated by dicing. In some embodiments, the wafer of FIG. 7A may be subjected to a combination of lithography and plasma dicing to open the metal free cutting streets followed by particle-lite dicing. FIG. 7C illustrates an assembly subsequent to stacking and bonding the IC dies 101 of FIG. 7B along surfaces 106. For example, the IC dies 101 may be bonded by oxide-oxide bonds. Any suitable type of IC dies 101 may be stacked and bonded. For example, although FIG. 7C shows IC dies 101 of the embodiment shown in FIG. 5A, any embodiments of the IC dies 101 shown in FIGS. 5A-5C may be included. Further, IC dies 101 may include any suitable circuitry, for example, IC dies 101 may be stacked such that IC dies 101 including memory circuitry alternate with IC dies 101 including compute circuitry. Although FIG. 7C shows a particular number of stacking and bonded IC dies 101, any suitable number of IC dies 101 may be stacked and bonded, as described above with reference to FIG. 1A. FIG. 7D illustrates the assembly of FIG. 7C subsequent to rotating the assembly 90 degrees such that bonding portions 124 exposed at surface 104 are facing upwards.

FIG. 7E illustrates an assembly subsequent to attaching multiple assemblies of FIG. 7D to a carrier 701 with bonding portions 124 at surface 104 facing away from the carrier 701. Carrier 701 may include any suitable carrier, for example, a semiconductor wafer, a glass wafer, or a ceramic wafer. The assemblies of FIG. 7D may be attached using any suitable technique, such as a temporary adhesive 702 or other release material. In some embodiments, the assemblies of FIG. 7D attached to carrier 701 may include known good dies (KGDs).

FIG. 7F illustrates an assembly subsequent to depositing an insulating material 126 on the assembly of FIG. 7E and between the stacked IC dies 101. The insulating material 126 may include any suitable material, as described above with reference to FIG. 1B, and may be deposited using any suitable technique, for example, wafer level compression molding. IC dies 101 may be spaced apart to facilitate deposition of the insulating material 126 between the stacked IC dies 101.

FIG. 7G illustrates an assembly subsequent to removing the carrier 701 and removing excess insulating material 126 from a top surface of the assembly of FIG. 7F to expose bonding portions 124 at surface 104. Carrier 701 may be removed using any suitable technique, such as laser debonding, or mechanical and chemical debonding and may be determined based on the temporary adhesive 702 used. Insulating material 126 may be removed using any suitable technique, such as chemical and mechanical polishing (CMP).

FIG. 7H illustrates an assembly subsequent to depositing a DB dielectric 108 on a top surface of the assembly of FIG. 7G and patterning to form openings 111. DB dielectric 108 may include any suitable material, for example, an inorganic dielectric (e.g., silicon carbonitride, which is preferred for low temperature hybrid bonding process flow) or an organic dielectric (e.g., curable polyimide), as described above with reference to FIG. 2. Any suitable deposition techniques may be used to deposit DB dielectric 108, such as PECVD, atomic layer deposition (ALD), or physical vapor deposition (PVD) processes such as sputter, spin-coating, or dip coating. The deposition technique used may be determined by a material of DB dielectric 108. DB dielectric 108 may have any suitable thickness, for example, as described above with reference to FIG. 3. The openings 111 may be created using any suitable technique, such as lithography and dry etch processes.

FIG. 7I illustrates an assembly subsequent to depositing a conductive material in the openings 111 of FIG. 7H to form DB contacts 110 and DB interface 180-1B. The conductive material may include any suitable material including NTC and may be deposited using any suitable technique, such as electroplating. In some embodiments, a barrier layer and/or a seed layer (not shown) may be deposited prior to electroplating NTC. NTC is a preferred conductive material due to low post-bond anneal temperature requirements. In some embodiments, a warpage correction process may be included between one or more of the various operations described in FIGS. 7A-7I.

FIGS. 8A-8F are schematic cross-sectional views of various stages of manufacture of an example microelectronic assembly, in accordance with various embodiments. FIG. 8A illustrates a wafer including IC dies 302 having TSVs 202 and DB interface 180-1A including DB dielectric 108 and DB contacts 110. FIG. 8B illustrates the wafer of FIG. 8A subsequent to dicing into IC dies 302. DB interface 180-1A of IC dies 302 may be formed using any suitable technique, such as described above with reference to FIGS. 7H and 7I, and may include any suitable dielectric material (e.g., silicon carbonitride) and conductive material (e.g., NTC, PCC, or FGC), as described above with reference to FIG. 3. The wafer of FIG. 8A may be subjected to particle-lite dicing to reduce the amount of particles generated by dicing. In some embodiments, the wafer of FIG. 8A may be subjected to a combination of lithography and plasma dicing to open the metal free cutting streets followed by particle-lite dicing.

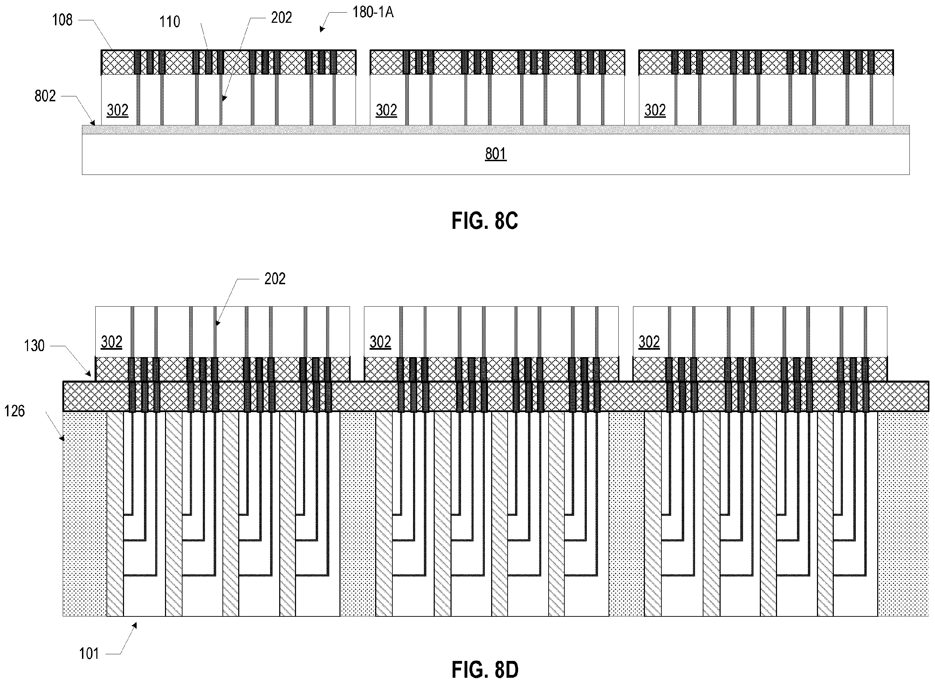

FIG. 8C illustrates an assembly subsequent to attaching multiple assemblies of FIG. 8B to a carrier 801 with the DB interface 180-1A facing away from the carrier 801. Carrier 801 may include any suitable carrier, for example, a semiconductor wafer, a glass wafer, or a ceramic wafer. The assemblies of FIG. 8B may be attached using any suitable technique, such as a temporary adhesive 802 or other release material. In some embodiments, the assemblies of FIG. 8B attached to carrier 801 may include KGDs.

FIG. 8D illustrates an assembly subsequent to inverting the assembly of FIG. 8C, placing the assembly of FIG. 8C on the assembly of FIG. 7I, aligning the DB contacts 110 of the DB interfaces 180-1A, 180-1B, forming interconnects 130 including metal-metal bonds and dielectric-dielectric bonds, as described above with reference to FIGS. 1 and 2, and removing the carrier 801. Interconnects 130 may be formed using any suitable process, for example, as described above. In some embodiments, interconnects 130 may be formed collectively (e.g., wafer level bonding). In some embodiments, interconnects 130 may be formed individually (e.g., die-to-die bonding). Carrier 801 may be removed using any suitable technique, such as described above with reference to FIG. 7G. In some embodiments, carrier 801 may be removed prior to forming interconnects 130. In some embodiments, carrier 801 may be removed subsequent to forming interconnects 130.

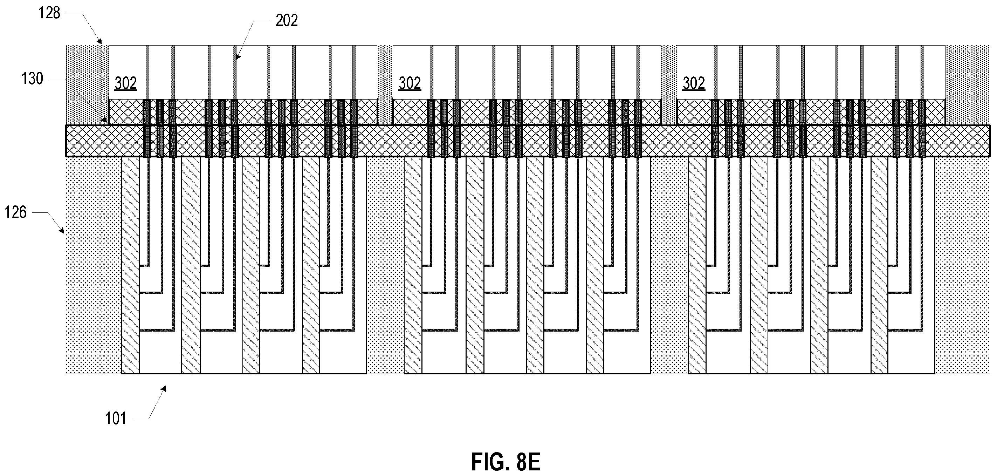

FIG. 8E illustrates an assembly subsequent to depositing a gap fill material 128 on the assembly of FIG. 8D and between IC dies 302, and removing excess gap fill material 128 from a top surface of the assembly to expose TSVs 202. The gap fill material 128 may include any suitable material, as described above with reference to FIG. 1B, and may be deposited using any suitable technique, for example, PECVD. IC dies 302 may be spaced apart to facilitate deposition of the gap fill material 128 between IC dies 302 (e.g., an aspect ratio of 1:1 for the gap may be preferred). The gap fill material 128 may be removed using any suitable technique, such as CMP. In some embodiments, IC dies 302 may be thinned (e.g., top surfaces of IC dies 302 may also be subject to CMP) to achieve a desired thickness. IC dies 302 may have any suitable dimensions, for example, IC dies 302, when attached to carrier 801, may have a thickness between 35 microns and 400 microns. In some embodiments, IC dies 302 may be subjected to CMP to thin IC dies 302 to have a thickness between 25 microns and 200 microns (e.g., a thickness between 30 microns and 50 microns).

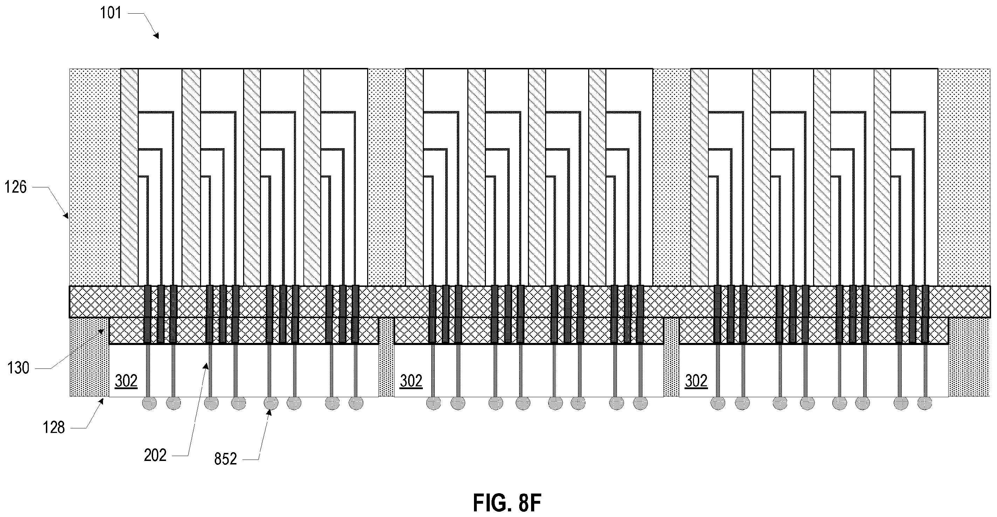

FIG. 8F illustrates an assembly subsequent to inverting the assembly of FIG. 8E and attaching solder 852 to a bottom surface of IC dies 302. The assembly of FIG. 8F may subsequently undergo singulation to form IC dies 101 and IC die 302 as shown in FIG. 1A (e.g., insulating material 126 and gap fill material 128 are completely removed during singulation) or as shown in FIG. 1B (e.g., insulating material 126 and gap fill material 128 are not removed during singulation). Further operations may be performed on the singulated assemblies, such as forming interconnects 352 between IC die 302 and package substrate 404 (e.g., by thermal compression bonding or by mass reflow), dispensing an underfill material 127 around interconnects 352, or electrically coupling package substrate 404 to a circuit board 131 by interconnects 150 to form a microelectronic assembly of FIG. 1. In some embodiments, a warpage correction process may be included between one or more of the various operations described in FIGS. 8A-8F.

### Example devices and components

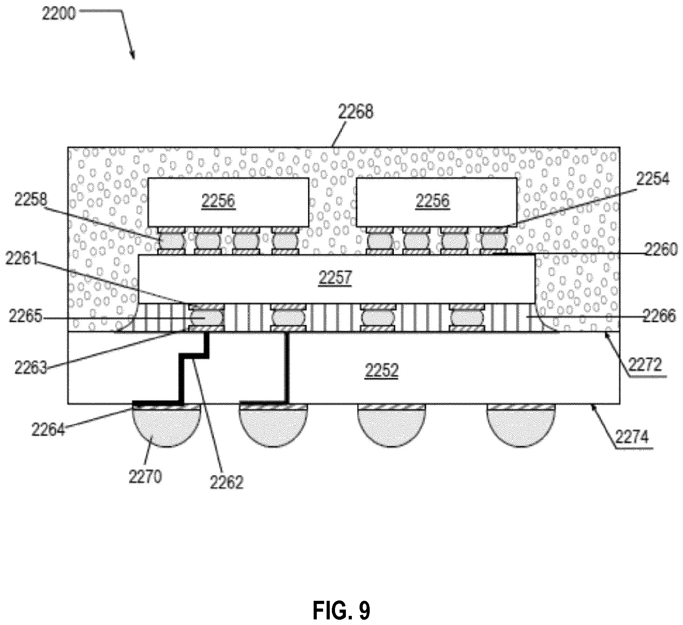

The packages disclosed herein, e.g., any of the embodiments shown in FIGS. 1-6 or any further embodiments described herein, may be included in any suitable electronic component. FIGS. 9-11 illustrate various examples of packages, assemblies, and devices that may be used with or include any of the microelectronic assemblies as disclosed herein.

FIG. 9 is a side, cross-sectional view of an example IC package 2200 that may include IC packages in accordance with any of the embodiments disclosed herein. In some embodiments, the IC package 2200 may be a SiP.

As shown in the figure, package substrate 2252 may be formed of an insulator (e.g., a ceramic, a buildup film, an epoxy film having filler particles therein, etc.), and may have conductive pathways extending through the insulator between first face 2272 and second face 2274, or between different locations on first face 2272, and/or between different locations on second face 2274. These conductive pathways may take the form of any of the interconnect structures comprising lines and/or vias.

Package substrate 2252 may include conductive contacts 2263 that are coupled to conductive pathway 2262 through package substrate 2252, allowing circuitry within dies 2256 and/or interposer 2257 to electrically couple to various ones of conductive contacts 2264 (or to other devices included in package substrate 2252, not shown).

IC package 2200 may include interposer 2257 coupled to package substrate 2252 via conductive contacts 2261 of interposer 2257, first-level interconnects 2265, and conductive contacts 2263 of package substrate 2252. First-level interconnects 2265 illustrated in the figure are solder bumps, but any suitable first-level interconnects 2265 may be used, such as solder bumps, solder posts, or bond wires.

IC package 2200 may include one or more dies 2256 coupled to interposer 2257 via conductive contacts 2254 of dies 2256, first-level interconnects 2258, and conductive contacts 2260 of interposer 2257. Conductive contacts 2260 may be coupled to conductive pathways (not shown) through interposer 2257, allowing circuitry within dies 2256 to electrically couple to various ones of conductive contacts 2261 (or to other devices included in interposer 2257, not shown). First-level interconnects 2258 illustrated in the figure are solder bumps, but any suitable first-level interconnects 2258 may be used, such as solder bumps, solder posts, or bond wires. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

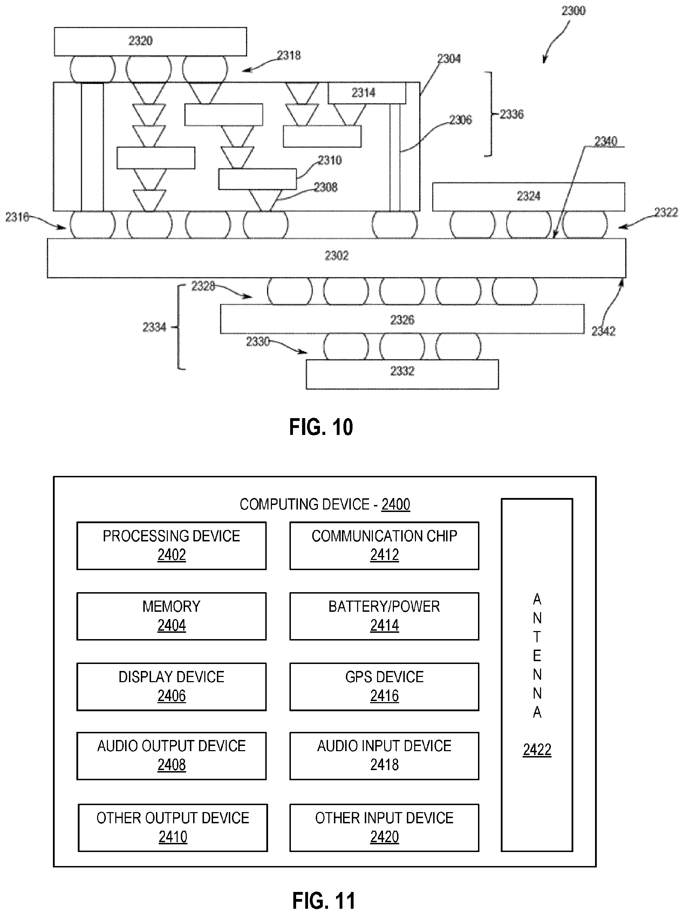

In some embodiments, underfill material 2266 may be disposed between package substrate 2252 and interposer 2257 around first-level interconnects 2265, and mold 2268 may be disposed around dies 2256 and interposer 2257 and in contact with package substrate 2252. In some embodiments, underfill material 2266 may be the same as mold 2268. Example materials that may be used for underfill material 2266 and mold 2268 are epoxies as suitable. Second-level interconnects 2270 may be coupled to conductive contacts 2264. Second-level interconnects 2270 illustrated in the figure are solder balls (e.g., for a ball grid array (BGA) arrangement), but any suitable second-level interconnects 2270 may be used (e.g., pins in a pin grid array arrangement or lands in a land grid array arrangement). Second-level interconnects 2270 may be used to couple IC package 2200 to another component, such as a circuit board (e.g., a motherboard), an interposer, or another IC package, as known in the art and as discussed below with reference to FIG. 10.

In various embodiments, any of dies 2256 may be microelectronic assembly 100 as described herein. In embodiments in which IC package 2200 includes multiple dies 2256, IC package 2200 may be referred to as a multi-chip package (MCP). Dies 2256 may include circuitry to perform any desired functionality. For example, besides one or more of dies 2256 being microelectronic assembly 100 as described herein, one or more of dies 2256 may be logic dies (e.g., silicon-based dies), one or more of dies 2256 may be memory dies (e.g., HBM), etc. In some embodiments, any of dies 2256 may be implemented as discussed with reference to any of the previous figures. In some embodiments, at least some of dies 2256 may not include implementations as described herein.

Although IC package 2200 illustrated in the figure is a flip-chip package, other package architectures may be used. For example, IC package 2200 may be a BGA package, such as an embedded wafer-level ball grid array (eWLB) package. In another example, IC package 2200 may be a wafer-level chip scale package (WLCSP) or a panel fan-out (FO) package. Although two dies 2256 are illustrated in IC package 2200, IC package 2200 may include any desired number of dies 2256. IC package 2200 may include additional passive components, such as surface-mount resistors, capacitors, and inductors disposed over first face 2272 or second face 2274 of package substrate 2252, or on either face of interposer 2257. More generally, IC package 2200 may include any other active or passive components known in the art.

In some embodiments, no interposer 2257 may be included in IC package 2200; instead, dies 2256 may be coupled directly to conductive contacts 2263 at first face 2272 by first-level interconnects 2265.

FIG. 10 is a cross-sectional side view of an IC device assembly 2300 that may include components having one or more microelectronic assembly 100 in accordance with any of the embodiments disclosed herein. IC device assembly 2300 includes a number of components disposed over a circuit board 2302 (which may be, e.g., a motherboard). IC device assembly 2300 includes components disposed over a first face 2340 of circuit board 2302 and an opposing second face 2342 of circuit board 2302; generally, components may be disposed over one or both faces 2340 and 2342. In particular, any suitable ones of the components of IC device assembly 2300 may include any of the one or more microelectronic assembly 100 in accordance with any of the embodiments disclosed herein; e.g., any of the IC packages discussed below with reference to IC device assembly 2300 may take the form of any of the embodiments of IC package 2200 discussed above with reference to FIG. 9.

In some embodiments, circuit board 2302 may be a PCB including multiple metal layers separated from one another by layers of insulator and interconnected by electrically conductive vias. Any one or more of the metal layers may be formed in a desired circuit pattern to route electrical signals (optionally in conjunction with other metal layers) between the components coupled to circuit board 2302. In other embodiments, circuit board 2302 may be a non-PCB package substrate.

As illustrated in the figure, in some embodiments, IC device assembly 2300 may include a package-on-interposer structure 2336 coupled to first face 2340 of circuit board 2302 by coupling components 2316. Coupling components 2316 may electrically and mechanically couple package-on-interposer structure 2336 to circuit board 2302, and may include solder balls (as shown), male and female portions of a socket, an adhesive, an underfill material, and/or any other suitable electrical and/or mechanical coupling structure.

Package-on-interposer structure 2336 may include IC package 2320 coupled to interposer 2304 by coupling components 2318. Coupling components 2318 may take any suitable form depending on desired functionalities, such as the forms discussed above with reference to coupling components 2316. In some embodiments, IC package 2320 may be or include IC package 2200, e.g., as described above with reference to FIG. 9. In some embodiments, IC package 2320 may include at least one microelectronic assembly 100 as described herein. Microelectronic assembly 100 is not specifically shown in the figure in order to not clutter the drawing.

Although a single IC package 2320 is shown in the figure, multiple IC packages may be coupled to interposer 2304; indeed, additional interposers may be coupled to interposer 2304. Interposer 2304 may provide an intervening package substrate used to bridge circuit board 2302 and IC package 2320. Generally, interposer 2304 may redistribute a connection to a wider pitch or reroute a connection to a different connection. For example, interposer 2304 may couple IC package 2320 to a BGA of coupling components 2316 for coupling to circuit board 2302.

In the embodiment illustrated in the figure, IC package 2320 and circuit board 2302 are attached to opposing sides of interposer 2304. In other embodiments, IC package 2320 and circuit board 2302 may be attached to a same side of interposer 2304. In some embodiments, three or more components may be interconnected by way of interposer 2304.

Interposer 2304 may be formed of an epoxy resin, a fiberglass-reinforced epoxy resin, a ceramic material, or a polymer material such as polyimide. In some implementations, interposer 2304 may be formed of alternate rigid or flexible materials that may include the same materials described above for use in a semiconductor substrate, such as silicon, germanium, and other group III-V and group IV materials. Interposer 2304 may include metal interconnects 2308 and vias 2310, including but not limited to TSVs 2306. Interposer 2304 may further include embedded devices 2314, including both passive and active devices. Such devices may include, but are not limited to, capacitors, decoupling capacitors, resistors, inductors, fuses, diodes, transformers, sensors, ESD devices, and memory devices. More complex devices such as radio frequency (RF) devices, power amplifiers, power management devices, antennas, arrays, sensors, and microelectromechanical systems (MEMS) devices may also be formed on interposer 2304. Package-on-interposer structure 2336 may take the form of any of the package-on-interposer structures known in the art.

In some embodiments, IC device assembly 2300 may include an IC package 2324 coupled to first face 2340 of circuit board 2302 by coupling components 2322. Coupling components 2322 may take the form of any of the embodiments discussed above with reference to coupling components 2316, and IC package 2324 may take the form of any of the embodiments discussed above with reference to IC package 2320.

In some embodiments, IC device assembly 2300 may include a package-on-package structure 2334 coupled to second face 2342 of circuit board 2302 by coupling components 2328. Package-on-package structure 2334 may include an IC package 2326 and an IC package 2332 coupled together by coupling components 2330 such that IC package 2326 is disposed between circuit board 2302 and IC package 2332. Coupling components 2328 and 2330 may take the form of any of the embodiments of coupling components 2316 discussed above, and IC packages 2326 and/or 2332 may take the form of any of the embodiments of IC package 2320 discussed above. Package-on-package structure 2334 may be configured in accordance with any of the package-on-package structures known in the art.

FIG. 11 is a block diagram of an example computing device 2400 that may include one or more components having one or more IC packages in accordance with any of the embodiments disclosed herein. For example, any suitable ones of the components of computing device 2400 may include a microelectronic assembly in accordance with any of the embodiments disclosed herein. In another example, any one or more of the components of computing device 2400 may include any embodiments of IC package 2200 (e.g., as shown in FIG. 9). In yet another example, any one or more of the components of computing device 2400 may include an IC device assembly 2300 (e.g., as shown in FIG. 10).

A number of components are illustrated in the figure as included in computing device 2400, but any one or more of these components may be omitted or duplicated, as suitable for the application. In some embodiments, some or all of the components included in computing device 2400 may be attached to one or more motherboards. In some embodiments, some or all of these components are fabricated onto a single system-on-chip (SOC) die.

Additionally, in various embodiments, computing device 2400 may not include one or more of the components illustrated in the figure, but computing device 2400 may include interface circuitry for coupling to the one or more components. For example, computing device 2400 may not include a display device 2406, but may include display device interface circuitry (e.g., a connector and driver circuitry) to which display device 2406 may be coupled. In another set of examples, computing device 2400 may not include an audio input device 2418 or an audio output device 2408, but may include audio input or output device interface circuitry (e.g., connectors and supporting circuitry) to which audio input device 2418 or audio output device 2408 may be coupled.

Computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. Processing device 2402 may include one or more DSPs, ASICs, CPUs, GPUs, cryptoprocessors (specialized processors that execute cryptographic algorithms within hardware), server processors, or any other suitable processing devices. Computing device 2400 may include a memory 2404, which may itself include one or more memory devices such as volatile memory (e.g., dynamic random access memory (DRAM)), nonvolatile memory (e.g., read-only memory (ROM)), flash memory, solid-state memory, and/or a hard drive. In some embodiments, memory 2404 may include memory that shares a die with processing device 2402. This memory may be used as cache memory and may include embedded dynamic random access memory (eDRAM) or spin transfer torque magnetic random access memory (STT-MRAM).

In some embodiments, computing device 2400 may include a communication chip 2412 (e.g., one or more communication chips). For example, communication chip 2412 may be configured for managing wireless communications for the transfer of data to and from computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 2412 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), LTE project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 2412 may operate in accordance with other wireless protocols in other embodiments. Computing device 2400 may include an antenna 2422 to facilitate wireless communications and/or to receive other wireless communications (such as AM or FM radio transmissions).

In some embodiments, communication chip 2412 may manage wired communications, such as electrical, optical, or any other suitable communication protocols (e.g., the Ethernet). As noted above, communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

Computing device 2400 may include battery/power circuitry 2414. Battery/power circuitry 2414 may include one or more energy storage devices (e.g., batteries or capacitors) and/or circuitry for coupling components of computing device 2400 to an energy source separate from computing device 2400 (e.g., AC line power).

Computing device 2400 may include a display device 2406 (or corresponding interface circuitry, as discussed above). Display device 2406 may include any visual indicators, such as a heads-up display, a computer monitor, a projector, a touchscreen display, a liquid crystal display (LCD), a light-emitting diode display, or a flat panel display, for example.

Computing device 2400 may include audio output device 2408 (or corresponding interface circuitry, as discussed above). Audio output device 2408 may include any device that generates an audible indicator, such as speakers, headsets, or earbuds, for example.

Computing device 2400 may include audio input device 2418 (or corresponding interface circuitry, as discussed above). Audio input device 2418 may include any device that generates a signal representative of a sound, such as microphones, microphone arrays, or digital instruments (e.g., instruments having a musical instrument digital interface (MIDI) output).

Computing device 2400 may include a GPS device 2416 (or corresponding interface circuitry, as discussed above). GPS device 2416 may be in communication with a satellite-based system and may receive a location of computing device 2400, as known in the art.

Computing device 2400 may include other output device 2410 (or corresponding interface circuitry, as discussed above). Examples of other output device 2410 may include an audio codec, a video codec, a printer, a wired or wireless transmitter for providing information to other devices, or an additional storage device.

Computing device 2400 may include other input device 2420 (or corresponding interface circuitry, as discussed above). Examples of other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, computing device 2400 may be any other electronic device that processes data.

### Select examples

The descriptions of illustrated implementations of the disclosure, including what is described in the abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

The following paragraphs provide various examples of the embodiments disclosed herein.

Example 1 is a microelectronic assembly, including a first integrated circuit (IC) die having a first surface, a second surface opposite the first surface, and a third surface orthogonal to the first and second surfaces, the first IC die including conductive traces parallel to the first and second surfaces and exposed at the third surface; and a second IC die having a fourth surface with conductive contacts, wherein the conductive traces exposed at the third surface of the first IC die are electrically coupled to the conductive contacts at the fourth surface of the second IC die by interconnects including metal-metal bonds and dielectric-dielectric bonds, and a material of the metal-metal bonds includes nanotwinned copper.

Example 2 may include the subject matter of Example 1, and may further specify that a material of the dielectric-dielectric bonds includes an inorganic dielectric.

Example 3 may include the subject matter of Example 1 or 2, and may further specify that a material of the dielectric-dielectric bonds includes an organic dielectric.

Example 4 may include the subject matter of any one of Examples 1-3, and may further specify that a thickness of the metal-metal bonds is between 100 nanometers and 600 nanometers.

Example 5 may include the subject matter of any one of Examples 1-4, and may further specify that the metal-metal bonds include first metal contacts at the third surface of the first IC die bonded to second metal contacts at the fourth surface of the second IC die, and wherein a material of the first metal contacts includes nanotwinned copper and a material of the second metal contacts includes nanotwinned copper, polycrystalline copper, or fine-grain copper.

Example 6 may include the subject matter of Example 5, and may further specify that a thickness of the metal-metal bonds is between 100 nanometers and 5.3 microns.

Example 7 may include the subject matter of any one of Examples 1-6, and may further specify that a thickness of the first IC die is between 1 millimeter and 5 millimeters.

Example 8 may include the subject matter of any one of Examples 1-7, and may further specify that a thickness of the second IC die is between 35 microns and 400 microns.

Example 9 may include the subject matter of any one of Examples 1-8, and may further specify that the first IC die includes a substrate and a metallization stack having an interface that is parallel to the first and second surfaces.

Example 10 may include the subject matter of any one of Examples 1-9, and may further specify that the first IC die includes a substrate and two metallization stacks on either side of the substrate having respective interfaces that are parallel to the first and second surfaces.

Example 11 may include the subject matter of any one of Examples 1-10, and may further specify that the first IC die includes a metallization stack and two substrates on either side of the metallization stack having respective interfaces that are parallel to the first and second surfaces.

Example 12 is a microelectronic assembly, including a plurality of first integrated circuit (IC) dies, wherein individual first IC dies of the plurality of first IC dies include a first surface, a second surface opposite the first surface, and a third surface orthogonal to the first and second surfaces, and conductive traces parallel to the first and second surfaces and exposed at the third surface; and a second IC die including a fourth surface with conductive contacts, wherein the conductive traces exposed at the third surface of the plurality of first IC dies are electrically coupled to the conductive contacts at the fourth surface of the second IC die by interconnects including metal-metal bonds and dielectric-dielectric bonds, and a material of the metal-metal bonds includes nanotwinned copper.

Example 13 may include the subject matter of Example 12, and may further specify that a material of the dielectric-dielectric bonds includes an inorganic dielectric.

Example 14 may include the subject matter of Example 13, and may further specify that the inorganic dielectric includes silicon, carbon, and nitrogen; silicon and nitrogen; silicon and oxygen; and combinations thereof.

Example 15 may include the subject matter of Example 14, and may further specify that the inorganic dielectric includes silicon, carbon, and nitrogen.

Example 16 may include the subject matter of any one of Examples 12-15, and may further specify that a material of the dielectric-dielectric bonds includes an organic dielectric.

Example 17 may include the subject matter of Example 16, and may further specify that the organic dielectric includes a curable polyimide.

Example 18 may include the subject matter of any one of Examples 12-17, and may further specify that some of the plurality of first IC dies include memory circuitry and some of the plurality of first IC dies include compute circuitry.

Example 19 may include the subject matter of any one of Examples 12-18, and may further specify that the material of the metal-metal bonds further includes polycrystalline copper or fine-grain copper.

Example 20 may include the subject matter of any one of Examples 12-19, and may further specify that the plurality of first IC dies are bonded together on respective first and second surfaces by oxide-oxide bonds.

Example 21 may include the subject matter of any one of Examples 12-20, and may further specify that the second IC die further includes a fifth surface opposite the fourth surface, and the microelectronic assembly may further include a package substrate electrically coupled to the fifth surface of the second IC die.

Example 22 is a microelectronic assembly, including a plurality of first integrated circuit (IC) dies, wherein individual first IC dies of the plurality of first IC dies include a first surface, a second surface opposite the first surface, and a third surface orthogonal to the first and second surfaces, conductive traces parallel to the first and second surfaces and exposed at the third surface, and a substrate and a metallization stack having an interface that is parallel to the first and second surfaces; and a second IC die including a fourth surface with conductive contacts, wherein the conductive traces exposed at the third surface of the plurality of first IC dies are electrically coupled to the conductive contacts at the fourth surface of the second IC die by interconnects including metal-metal bonds and dielectric-dielectric bonds, and a material of the metal-metal bonds includes nanotwinned copper.

Example 23 may include the subject matter of Example 22, and may further specify that a material of the dielectric-dielectric bonds includes an inorganic dielectric.

Example 24 may include the subject matter of Example 23, and may further specify that the inorganic dielectric includes silicon, carbon, and nitrogen; silicon and nitrogen; silicon and oxygen; and combinations thereof.

Example 25 may include the subject matter of any one of Examples 22-24, and may further specify that some of the plurality of first IC dies include memory circuitry and some of the plurality of first IC dies include compute circuitry.

Example 26 may include the subject matter of any one of Examples 22-25, and may further specify that the plurality of first IC dies are bonded together on respective first and second surfaces by oxide-oxide bonds.

Example 27 may include the subject matter of any one of Examples 22-26, and may further specify that the second IC die further includes a fifth surface opposite the fourth surface, and the microelectronic assembly may further include a package substrate electrically coupled to the fifth surface of the second IC die.

Example 28 may include the subject matter of any one of Examples 22-27, and may further specify that the material of the metal-metal bonds further includes polycrystalline copper or fine-grain copper.

Example 29 may include the subject matter of any one of Examples 22-28, and may further specify that some of the plurality of first IC dies include memory circuitry and some of the plurality of first IC dies include compute circuitry.

## Claims

1. A microelectronic assembly, comprising:
a first integrated circuit (IC) die having a first surface, a second surface opposite the first surface, and a third surface orthogonal to the first and second surfaces, the first IC die including conductive traces parallel to the first and second surfaces and exposed at the third surface; and
a second IC die having a fourth surface with conductive contacts, wherein the conductive traces exposed at the third surface of the first IC die are electrically coupled to the conductive contacts at the fourth surface of the second IC die by interconnects including metal-metal bonds and dielectric-dielectric bonds, and a material of the metal-metal bonds includes nanotwinned copper.

2. The microelectronic assembly of claim 1, wherein a thickness of the metal-metal bonds is between 100 nanometers and 600 nanometers.

3. The microelectronic assembly of claim 1 or 2, wherein the metal-metal bonds include first metal contacts at the third surface of the first IC die bonded to second metal contacts at the fourth surface of the second IC die, and wherein a material of the first metal contacts includes nanotwinned copper and a material of the second metal contacts includes nanotwinned copper, polycrystalline copper, or fine-grain copper.

4. The microelectronic assembly of claim 3, wherein a thickness of the metal-metal bonds is between 100 nanometers and 5.3 microns.

5. The microelectronic assembly of any one of claims 1-4, wherein a thickness of the first IC die is between 1 millimeter and 5 millimeters.

6. The microelectronic assembly of any one of claims 1-5, wherein a thickness of the second IC die is between 35 microns and 400 microns.

7. The microelectronic assembly of any one of claims 1-6, wherein the first IC die includes a substrate and a metallization stack having an interface that is parallel to the first and second surfaces.

8. The microelectronic assembly of any one of claims 1-6, wherein the first IC die includes a substrate and two metallization stacks on either side of the substrate having respective interfaces that are parallel to the first and second surfaces.

9. The microelectronic assembly of any one of claims 1-6, wherein the first IC die includes a metallization stack and two substrates on either side of the metallization stack having respective interfaces that are parallel to the first and second surfaces.

10. The microelectronic assembly of any one of claims 1-9, wherein the first IC die is one of a plurality of first IC dies.

11. The microelectronic assembly of any one of claims 1-10,wherein a material of the dielectric-dielectric bonds includes an inorganic dielectric.

12. The microelectronic assembly of claim 11, wherein the inorganic dielectric includes silicon, carbon, and nitrogen; silicon and nitrogen; silicon and oxygen; and combinations thereof.

13. The microelectronic assembly of any one of claims 1-10, wherein a material of the dielectric-dielectric bonds includes an organic dielectric.

14. The microelectronic assembly of claim 10, wherein some of the plurality of first IC dies include memory circuitry and some of the plurality of first IC dies include compute circuitry.

15. The microelectronic assembly of claim 10, wherein the plurality of first IC dies are bonded together on respective first and second surfaces.
